(19) Europäisches Patentamt / European Patent Office / Office européen des brevets

(11) **EP 3 254 423 B1**

(12) **FASCICULE DE BREVET EUROPEEN**

(45) Date de publication et mention
de la délivrance du brevet:
**02.01.2019 Bulletin 2019/01**

(21) Numéro de dépôt: **16705244.8**

(22) Date de dépôt: **29.01.2016**

(51) Int Cl.:
*H04L 27/20* [(2006.01)]    *H04L 27/22* [(2006.01)]
*H04L 27/32* [(2006.01)]

(86) Numéro de dépôt international:
**PCT/FR2016/050193**

(87) Numéro de publication internationale:
**WO 2016/124841 (11.08.2016 Gazette 2016/32)**

(54) **PROCÉDÉ ET DISPOSITIF DE MODULATION DE PHASE D'UNE ONDE PORTEUSE ET APPLICATION À LA DÉTECTION DE SIGNAUX NUMÉRIQUES MULTI-NIVEAUX CODÉS EN PHASE**

VERFAHREN UND VORRICHTUNG ZUR PHASENMODULATION EINER TRÄGERWELLE UND VERWENDUNG ZUR ERKENNUNG VON MEHRSTUFIGEN PHASENCODIERTEN DIGITALEN SIGNALEN

METHOD AND DEVICE FOR PHASE MODULATION OF A CARRIER WAVE AND APPLICATION TO THE DETECTION OF MULTI-LEVEL PHASE-ENCODED DIGITAL SIGNALS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.02.2015 FR 1550809**

(43) Date de publication de la demande:
**13.12.2017 Bulletin 2017/50**

(73) Titulaire: **Commissariat à l'Énergie Atomique et aux Énergies Alternatives
75015 Paris (FR)**

(72) Inventeurs:
• **GLATTLI, Denis, Christian
92160 Antony (FR)**
• **ROULLEAU, Séverin, Preden
75013 Paris (FR)**

(74) Mandataire: **Delumeau, François Guy et al
Cabinet Beau de Loménie
158, rue de l'Université
75340 Paris Cedex 07 (FR)**

(56) Documents cités:
**US-A1- 2007 092 018     US-A1- 2012 087 403**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

Domaine de l'invention

La présente invention concerne un procédé de modulation de phase d'une onde porteuse, laquelle onde porteuse peut être de type électromagnétique, depuis le domaine des basses fréquences jusqu'au domaine optique, ou de type acoustique.

L'invention concerne également une application à un procédé de transport d'une information binaire par codage de phase à bande latérale unique (BLU).

L'invention concerne encore un procédé de génération de signaux orthogonaux à bande latérale unique, en vue d'une application au codage et à la détection de signaux numériques multi-niveaux à BLU.

L'invention a encore pour objet un procédé d'émission en phase et hors phase de signaux binaires codés en phase à bande latérale unique.

L'invention concerne encore une application à un procédé de modulation mixte amplitude-phase à bande latérale unique.

L'invention a encore pour objet des dispositifs pour la mise en oeuvre des procédés précités.

Art antérieur

Dès les premiers développements de la téléphonie, puis de la radio, les signaux à diffuser ont été transportés par l'intermédiaire de modulation en amplitude ou en phase d'une onde porteuse sinusoïdale de fréquence plus élevée que le domaine spectral de ces signaux. Dans tous les procédés connus, on trouve que la modulation génère un spectre de fréquence bilatéral, c'est-à-dire avec des composantes de fréquences au-dessus et en-dessous de la fréquence porteuse. En général, l'information contenue dans la bande supérieure est la même que celle contenue dans la bande inférieure.

Aussi les ingénieurs ont cherché à trouver des solutions pour ne garder qu'une bande latérale afin d'optimiser l'occupation de la bande de fréquence allouée (voir notamment le document US 1449382). En effet, si chaque utilisateur occupe un espace de fréquence plus petit, le nombre d'utilisateurs sera augmenté et les coûts par utilisateurs seront diminués.

Le procédé courant pour obtenir une bande latérale unique (BLU), (ou en anglais « single side-band » ou « SSB »), consiste à supprimer, après génération du signal modulé, la bande latérale non-désirée. Le plus simple est le filtrage de type passe-bande.

Une méthode plus performante est le filtrage par transformée de Hilbert. Proposée par Hartley dès 1928 (voir le document US 1666206), elle consiste, en utilisant un déphaseur large bande à 90°, à construire la somme (respectivement la différence) de la partie en phase et de celle en quadrature du signal modulé pour obtenir la bande latérale supérieure (respectivement inférieure).

Le document US 2007/0092018 A1 divulgue aussi une technique de modulation SSB-FM (PM) avec la transformée de Hilbert.

Une variante a ensuite été proposée par Weaver, dans l'article de D. K. Weaver Jr., intitule "A third method of generation and detection of single-sideband signals" paru dans "Proceeding of the IRE", pp 1703-1705, Juin 1956.

La méthode par transformée de Hilbert est particulièrement adaptée de nos jours grâce aux calculateurs digitaux embarqués (en anglais « Digital Signal Processor » ou « DSP »).

Par ailleurs, pour de nombreuses applications, on cherche à générer des signaux orthogonaux à bande latérale unique.

L'utilisation de forme d'ondes orthogonales a de nombreuses applications allant de l'analyse de signaux à la transmission de signaux. Dans ce dernier cas, l'application visée est le multiplexage de données. Les premières approches ont consisté à effectuer la modulation en amplitude d'une onde porteuse par un signal formé de la somme de signaux orthogonaux multipliés par le bit d'information à transporter.

Par orthogonal on entend que l'intégrale du produit de deux formes d'onde distinctes soit nul sur une durée finie (ici la durée $T_s$ d'émission d'une forme d'onde (ou 'symbole') codant un bit d'information). Un exemple de fonctions d'onde mutuellement orthogonales est donné par l'ensemble :

$$\sin 2 \cdot t/T_s, \ \sin 4 \cdot t/T_s, \ \sin 6 \cdot t/T_s, \ \text{etc, ... .}$$

Des variantes utilisant la génération de polynômes orthogonaux ont été décrites dans le document US 3204034.

On a également proposé des variantes utilisant la génération de fonctions d'Hermite, comme par exemple dans le document US 3384715.

On peut noter que la modulation par les fonctions sinus mentionnées plus haut revient aussi à une modulation de fréquence (et donc de la phase) où la fréquence de la porteuse $f_C$ prend les valeurs $f_C+/-1/T_s$, $f_C+/-2/T_s$, $f_C+j-3/T_s$, etc, .... C'est cette dernière solution qui a été le plus développée dans le domaine des transmissions de données numériques. Le procédé est appelé en anglais « Orthogonal Frequency Division Multiplexing » ou « OFDM » et est décrit notamment dans le document US 3488445. Il est utilisé par exemple pour l'ADSL, la radio- ou télédiffusion numérique terrestre et plus récemment dans les réseaux mobiles en 4G.

A partir d'une fréquence porteuse on utilise une série de fréquences sous-porteuses qui chacune transporte une information binaire. Chaque sous-porteuse est le vecteur d'un canal d'information binaire, l'utilisation simultanée des N sous-porteuses permettant le multiplexage de N bits. Dans ce procédé, les signaux portés par chaque sous-porteuse doivent avoir la propriété d'orthogonalité afin d'éviter l'interférence entre canaux et de pouvoir retrouver, après démodulation, l'information de chaque canal.

L'orthogonalité est assurée si la distance entre fréquences sous-porteuses est multiple de l'inverse de la durée d'un symbole $T_s$. Pendant la durée d'émission $T_s$, le signal de modulation de N bits transmis en parallèle est généré par la transformée de Fourier des N bits et est ensuite multiplié à la fréquence porteuse. A la réception, après démodulation de la porteuse pour retrouver le signal de modulation, une transformée de Fourier inverse est appliquée à ce dernier afin de retrouver la valeur portée par chacun des N bits.

Les procédés décrits dans le paragraphe précédent génèrent tous un signal à double bande latérale. La génération de fonctions orthogonales nécessite aussi pour leur synthèse une opération analogique ou numérique complexe (dérivations et sommations multiples pour des polynômes orthogonaux ou les fonctions d'Hermite, transformation de Fourier pour l'OFDM).

On présente par ailleurs ci-dessous un bref historique du codage de phase.

La transmission de donnée numérique par codage binaire de phase (ou son équivalent par décalage de phase) est couramment utilisée dans les communications numériques modernes. Différentes formes ont été utilisées.

La plus simple, appelée en anglais « Binary phase shift keying » ou « B-PSK », consiste à moduler la phase d'une porteuse de la quantité 0 ou $\pi$. Pour transmettre le k$^{ième}$ bit de durée $T_b$ dans l'intervalle de temps $(k-1)T_b < t \leq kT_b$, la phase prend la valeur constante $b_k\pi$ où $b_k$ = 1 pour le bit '1' et $b_k$ = 0 pour le bit '0'.

Pour permettre un meilleur taux de transmission de l'information, le principe a été étendu à une modulation en quadrature (en anglais « Quadrature Phase Shift Keying » ou « Q-PSK ») où pour k pair la phase vaut $b_k\pi$ dans l'intervalle $(k-1)T_b < t \leq kT_b$ et pour k impair, la phase vaut $\pi/2+b_k\pi$ dans l'intervalle décalé $(k-1/4)T_b < t \leq (k+1/4)T_b$.

Les discontinuités temporelles de la phase introduisant des queues de densité spectrale décroissant lentement de part et d'autre de la fréquence porteuse, des modulations plus douces de la phase ont été introduites afin d'avoir un spectre plus compact et de réduire ainsi les interférences entre signaux numériques indépendants transportés par des porteuses de fréquence adjacente, comme décrit par exemple dans le document US 2977417.

Par exemple les procédés de codage par variation de fréquence, dits en anglais de « Frequency Shift Keying » ou « FSK », font une interpolation linéaire de la variation de phase dans le temps (ce qui revient à réaliser un décalage de fréquence d'où l'appellation FSK). La phase est alors continue mais sa dérivée ne l'est pas.

La modulation la plus aboutie dans ce sens est obtenue par le procédé de modulation à déphasage minimum gaussien appelé en anglais « Gaussian Minimum-Shift Keying » ou « GMSK » et est utilisée par exemple en téléphonie GSM (voir par exemple l'article de H. E. Rowe et V. K. Prabhu, intitulé « Power spectrum of a digital, frequency-modulation signal », paru dans The Bell System Technical Journal, 54, No 6, pages 1095-1125 (1975).

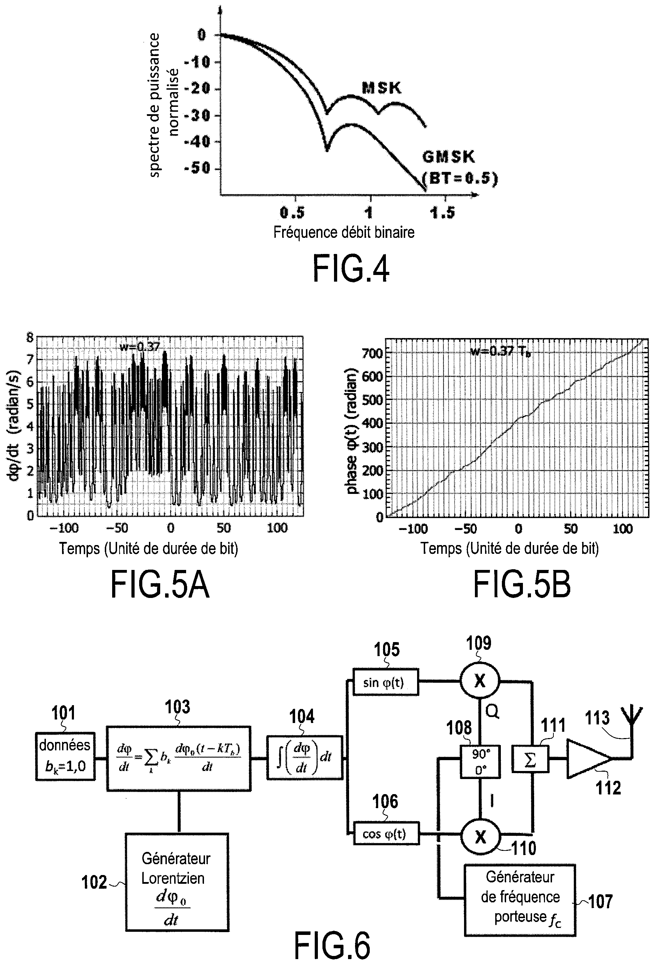

Dans ce procédé, lors de l'émission d'un bit de donnée, la dérivée de la phase est un signal carré positif (bit 1) ou négatif (bit 0) de durée $T_b$ convolué avec une fonction Gaussienne afin d'atténuer les discontinuités. La modulation de la phase de la porteuse est ensuite obtenue par intégration de sa dérivée et l'amplitude d'incrément de phase est ajustée pour avoir $+\pi/2$ pour le bit 1 ou $-\pi/2$ pour le bit 0. Le procédé GMSK permet d'avoir une étendue spectrale très contenue, avec typiquement une puissance spectrale réduite de -20dB au-delà des fréquences $f_C \pm 1/2T_b$. Ceci est illustré sur la figure 4 où seule la bande supérieure du spectre bilatéral est montrée.

Tous ces procédés donnent un spectre à double bande latérale.

Objet et description succincte de l'invention

Comme on l'a vu plus haut, il n'existe pas de système connu de modulation possédant la propriété de générer directement une bande latérale unique. Par 'directement' on entend une génération sans post traitement comme décrit ci-dessus.

La présente invention vise à répondre à cette lacune et à permettre la génération directe d'un signal modulé à bande latérale unique.

L'invention répond donc aux problèmes de l'art antérieur grâce à un procédé de modulation de phase d'une onde porteuse, caractérisé en ce que l'on crée un ensemble de signaux $s_h(t)$ constitués d'une onde de fréquence porteuse $f_C$ dont la phase $\varphi(t)=h\varphi_0(t)$ est modulée dans le temps $t$ de telle sorte que $s_h(t)=\cos(2\pi f_C t+h\varphi_0(t))$, où $h$ est un nombre entier et où $\varphi_0(t) = 2 \arctan((t-t_0)/w_0)$, la modulation correspondant à une impulsion de phase unique centrée au temps $t_0$ de durée caractéristique $w_0$ positive et incrémentant la phase du signal $s_h(t)$ de la quantité $h2\pi$, de telle sorte que l'on génère directement un spectre de fréquence à bande latérale unique.

L'onde porteuse peut être de type électromagnétique, depuis les basses fréquences jusqu'aux fréquences optiques, ou de type acoustique.

L'invention concerne encore un procédé de transport d'une information binaire par codage de phase à bande latérale unique appliquant le procédé de modulation selon l'invention, caractérisé en ce que pour le codage binaire de la phase, on établit que le $k^{\text{ième}}$ bit de durée $T_b$ contribue à la phase totale $\varphi(t)$ de la porteuse par la quantité $2 \, b_k \arctan((t-kT_b)/w)$ où $b_k = 1$ ou $0$ et la largeur $w$ est comparable ou plus petite que la durée du symbole $T_b$ ou on considère que la dérivée de la phase est une somme de Lorentziennes $2w/((t-kT_b)^2 + w^2)$ centrées en $k \, T_b$ et pondérées par le bit $b_k$ puis on intègre la phase qui est ensuite adjointe à la porteuse suivant un procédé de modulation de phase, les quantités $\cos \varphi(t)$ et $\sin \varphi(t)$ qui sont les composantes en phase et en quadrature du signal de modulation étant calculées et combinées aux amplitudes en phase $\cos 2\pi f_C t$ et en quadrature $\sin 2\pi f_C t$ de la porteuse pour obtenir le signal à transmettre sous la forme: $s(t)=\cos(2\pi f_C t+\varphi(t))=\cos(2\pi f_C t)\cos\varphi(t)-\sin(2\pi f_C t)\sin\varphi(t)$ .

L'invention concerne encore un procédé de génération de signaux orthogonaux à bande latérale unique appliquant le procédé de modulation selon l'invention, caractérisé en ce que pour générer un ensemble de fonctions orthogonales $u_h(t)$, $h = 1,2,3, ...,N$ sur une durée finie $T_b$. pour leur exploitation en transmission de données avec un débit $1/ T_b$ par canal d'information, on considère d'abord le cas où $T_b$ est infini, ce qui définit une impulsion unique et on établit une base de fonctions orthogonales de la forme
$$u_h(t) = \frac{1}{\sqrt{2\pi}} e^{ih\,\varphi_0(t)} \sqrt{\frac{d\varphi_0(t)}{dt}} = \frac{1}{\sqrt{2\pi}} \frac{(t+iw)^{h-1}}{(t-iw)^h} \quad \text{où}$$

la phase est $\varphi_0(t)=2 \arctan(t/w)$ ou on considère les signaux
$$s_h(t) = e^{ih\,\varphi_0(t)} = \frac{(t+iw)^h}{(t-iw)^h} \quad \text{puis on assure la séparation}$$

par orthogonalité de deux signaux $s_h(t)$ et $s_{h'}(t)$ en effectuant l'intégration suivante
$$\frac{1}{2\pi} \int_{-\infty}^{+\infty} s_{h'}^*(t) \, s_h(t) \frac{d\varphi_0}{dt} \, dt = \delta_{h,h'}$$

$$\frac{d\varphi_0}{dt} = 2w/(t^2 + w^2)$$
où apparaît comme un poids pour l'intégration, les signaux $s_h(t)$ étant à amplitude constante et le spectre des signaux $s_h(t)$ étant à bande latérale unique.

Selon un aspect particulier de ce procédé, on généralise à des fonctions orthogonales sur un intervalle non plus infini mais fini $T_b$ en considérant une série périodique d'impulsions de phase espacées de la durée $T_b$ afin d'obtenir

$$s_h(t) = e^{ih\,\varphi_0(t,T_b)} = \left( \frac{\sin(\pi(t+iw)/T_b)}{\sin(\pi(t-iw)/T_b)} \right)^h \, ,$$
des signaux périodiques de la forme où la dérivée de la phase $\varphi_0$ est une somme périodique de fonctions lorentziennes, cette somme pouvant se réécrire sous la forme d'une fonction

$$\frac{d\varphi_0}{dt} = \frac{\pi}{T_b} \cdot \frac{sh(2\pi w/T_b)}{\sin^2(\pi t/T_b) + sh^2(\pi w/T_b)}$$
périodique de la forme: où deux signaux différents par les entiers $h$ et $h'$

vérifient une relation d'orthogonalité sur l'intervalle de temps $T_b$ :
$$\frac{1}{2\pi} \int_{-T_b/2}^{+T_b/2} s_{h'}^*(t) \, s_h(t) \frac{d\varphi_0}{dt} \, dt = \delta_{h,h'} \, , \quad \frac{d\varphi_0}{dt} \quad \text{jouant}$$

le rôle de poids pour l'intégration, de telle sorte qu'en calculant $\dfrac{d\varphi_0}{dt}$ puis en procédant à une intégration pour obtenir la phase $\varphi_0(t,T_b)$ avant de synthétiser le signal $s_h(t)=e^{ih\varphi_0(t,T_b)}$, on obtient, avec une simple multiplication de la phase par un nombre entier, un jeu de signaux d'amplitude constante présentant le caractère d'orthogonalité et on obtient un spectre, discret, qui conserve la propriété de bande latérale unique.

Le procédé selon l'invention est ainsi un nouveau procédé de modulation de phase qui se démarque en ce qu'il génère des signaux orthogonaux avec un spectre présentant une bande latérale unique et que les fonctions orthogonales utilisées d'ordre N>1 sont générées en multipliant simplement par un nombre entier la phase servant à générer la fonction orthogonale d'ordre 1.

Alors que l'OFDM présente un spectre bilatéral de largeur N/ $T_s$ flanqué de queues de spectre décroissant lentement (loi de puissance), l'invention propose un multiplexage dont le spectre est sans bande latérale inférieure et dont la bande supérieure a une largeur principale N/ $T_s$ avec une queue de spectre décroissant exponentiellement rapidement.

Il est naturellement également possible, par un renversement du signe de la phase, de réaliser un multiplexage dont le spectre est sans bande latérale supérieure et dont la bande inférieure a une largeur principale N/ $T_s$ avec une queue de spectre décroissant exponentiellement rapidement.

L'invention concerne encore un procédé d'émission en phase et hors phase de signaux binaires codés en phase à bande latérale unique appliquant le procédé de modulation selon l'invention, caractérisé en ce que l'on module indépendamment la composante en phase et la composante en quadrature de la porteuse afin de doubler le débit d'information, le signal considéré étant de la forme suivante en étant constitué de la somme de deux amplitudes et n'étant pas à amplitude constante :

$$s(t) = \cos(2\pi f_C t + \varphi_1(t)) + \sin(2\pi f_C t + \varphi_2(t))$$

avec les phases $\varphi_1(t) = \sum_k b_{k,1} \varphi_0(t - kT_b)$ et $\varphi_2(t) = \sum_k b_{k,2} \varphi_0(t - kT_b)$ où l'on utilise deux jeux de bits indépendants $b_{k,1(2)}$ pour doubler le débit, le spectre de chacune des amplitudes hors phase et en phase étant à bande latérale unique, le signal total présentant lui-même la propriété de bande latérale unique.

L'invention a encore pour objet un procédé de modulation mixte du signal d'une porteuse à la fois en amplitude et en phase en appliquant le procédé de modulation selon l'invention, caractérisé en ce que pour des impulsions où la phase est exprimée sous la forme $\varphi(t) = h\varphi_0(t)$ ($h$ = 1,2,3, ...) on produit un signal de la forme

$$s(t) = \cos(2\pi f_C t) - (-1)^h \cos(2\pi f_C t + h \varphi_{\grave{a}}(t))$$

où le spectre résultant est à bande latérale unique.

L'invention concerne encore un dispositif de génération d'impulsions de phase à bande latérale unique, pour la mise en oeuvre du procédé selon l'invention, caractérisé en ce qu'il comprend un processeur rapide dédié DSP ou un processeur rapide reconfigurable FPGA, un convertisseur numérique/analogique, des premier et deuxième modules de détermination respectivement des quantités sin $\varphi(t)$ et cos $\varphi(t)$, des premier et deuxième mélangeurs pour multiplier par lesdites quantités sin $\varphi(t)$ et cos $\varphi(t)$ respectivement la partie en phase et la partie en quadrature de phase de l'onde de fréquence porteuse $f_C$ et un circuit additionneur pour combiner les signaux délivrés par lesdits premier et deuxième mélangeurs.

De façon plus particulière, l'invention a encore pour objet un dispositif de génération d'impulsions de phase à bande latérale unique, pour la mise en oeuvre du procédé selon l'invention, caractérisé en ce qu'il comprend un dispositif analogique de génération de 2N séquences périodiques d'impulsions $d\varphi_{0,s}(t)/dt$ de période $2NT_b$, chaque séquence étant décalée en temps de la précédente par $T_b$., le dispositif analogique utilisant une phase élémentaire $\varphi_{0,s}(t)$ telle que le recouvrement entre impulsions de phases séparées de $2NT_b$ soit négligeable, afin d'obtenir une synthèse de $d\varphi(t)/dt$ et un dispositif de génération d'harmoniques de fréquence multiples de $1/2NT_b$ pour synthétiser une séquence périodique de signaux

$$d\varphi_{0,s}{}^q(t)/dt = \sum_{k=-\infty}^{+\infty} d\varphi_{0,s}(t - (k+q)T_b)/dt \qquad , -N \le q < N ,$$

un démultiplexeur configuré pour, dans l'intervalle de temps $(k-N+1/2)/2T_b \le t < (k+N-1/2)/T_b$, démultiplexer les bits afin de les indexer comme $b_{k+q}$ et en utilisant la fonction porte $\Pi(t)$ de largeur $2NT_b$ construire la dérivée de la phase totale :

$$d\varphi(t)/dt = \sum_{q=-N}^{+N} b_{k+q} \Pi(t - (k+q)T_b) \, d\varphi_{0,s}(t - (k+q)T_b)/dt$$

L'invention concerne également un dispositif de démodulation d'un signal codé en phase à bande latérale unique, caractérisé en ce qu'il comprend un oscillateur local de fréquence $f_C$, des premier et deuxième mélangeurs, et un déphaseur 0°- 90° permettant d'obtenir respectivement des composantes en phase et en quadrature $\cos(\varphi(t))$ et $\sin(\varphi(t))$ du signal de modulation, un module de dérivation de chacune des composantes en phase et en quadrature

cos($\varphi(t)$) et sin($\varphi(t)$) du signal de modulation et de multiplication de chacune des dérivées obtenues par l'autre des composantes en phase et en quadrature cos($\varphi(t)$) et sin($\varphi(t)$) du signal de modulation, afin d'obtenir la dérivée de la phase $d\varphi/dt = \cos\varphi(t)d(\sin\varphi(t))/dt - \sin\varphi(t)d(\cos\varphi(t))/dt$, et un module de reconstitution d'une série d'impulsions lorentziennes initialement générées, comprenant un détecteur de seuil avec une valeur moitié de l'amplitude d'une impulsion lorentzienne unique de manière à assurer la discrimination de la valeur d'un bit $b_k = 1$ ou 0 à un temps $t_k = kT_b$.

L'invention a encore pour objet un dispositif de démodulation de signaux par une base de signaux périodiques orthogonaux comprenant quatre niveaux d'amplitude incluant l'amplitude nulle, caractérisé en ce qu'il comprend un oscillateur local de fréquence $f_C$, des premier et deuxième mélangeurs, et un déphaseur 0°- 90° permettant d'obtenir respectivement des composantes en phase et en quadrature cos($\varphi(t)$) et sin($\varphi(t)$) du signal de modulation, un dispositif de détection séparée des quatre niveaux $h$=0, 1, 2 et 3 des bits quaternaires en formant pour chacun des quatre niveaux d'amplitude, par un module de démodulation associé à un générateur lorentzien de période $T_b$, les deux quantités

$$R_h(t) = \left(\cos(\varphi(t) - h\varphi_0(t, T_b))\right)\frac{d\varphi_0}{dt} \text{ et } I_h(t) = \left(\sin(\varphi(t) - h\varphi_0(t, T_b))\right)\frac{d\varphi_0}{dt} ,$$

un dispositif de détermi-

$$\overline{R_h}(t) = \int_{t-T_b/2}^{t+T_b/2} R_h(t-\tau)d\tau$$

nation de la convolution avec une fonction porte de largeur en temps $T_b$ donnant $\qquad\qquad$ et

$$\overline{I_h}(t) = \int_{t-T_b/2}^{t+T_b/2} I_h(t-\tau)dt$$

à partir des quantités $R_h(t)$ et $I_h(t)$, un dispositif de calcul de la quantité $\overline{R_h}(t)^2 + \overline{I_h}(t)^2$ et un dispositif de détection de seuil configuré pour déterminer qu'un pic observé dans cette quantité $\overline{R_h}(t)^2 + \overline{I_h}(t)^2$ à un instant $t = kT_b$ pour le niveau $h$=0, 1, 2 ou bien 3 signale que le bit $b_k$ vaut $h$.

L'invention concerne encore un dispositif de génération d'impulsions de phase à bande latérale unique dans le domaine optique, caractérisé en ce qu'il comprend un module de fourniture des données $b_k$=1 ou 0, un générateur de lorentzienne, un module de génération de phase, un module d'intégration de phase, un générateur laser de fréquence porteuse et un modulateur de phase électro-optique configuré pour moduler directement la phase de l'onde, de telle sorte que, sous l'effet d'une tension proportionnelle à la variation de phase voulue, un signal optique à modulation de phase BLU est généré dans le modulateur pour être transmis dans un réseau de communication optique.

Brève description des dessins

D'autres caractéristiques et avantages de l'invention ressortiront de la description suivante de modes particuliers de réalisation, donnés à titre d'exemples, en référence aux dessins annexés, sur lesquels :

Les Figures 1A à 1C représentent des courbes donnant la densité spectrale des spectres à bande latérale unique de signaux correspondant à une impulsion de phase unique dont la porteuse est modulée en phase pour différentes valeurs du nombre entier h définissant l'indice de modulation, conformément à un aspect de l'invention;
Les Figures 2A et 2B représentent des courbes donnant la densité spectrale des spectres de signaux dont la porteuse est modulée en phase pour différentes valeurs d'un nombre non entier définissant la modulation;
Les Figure 3A et 3B représentent des courbes donnant la densité spectrale des spectres à bande latérale unique de signaux dont la porteuse est modulée en phase pour différentes valeurs de gaussiennes en définissant une modulation présentant un caractère de BLU proche de 100%, conformément à un aspect de l'invention ;
La Figure 4 représente des courbes donnant l'amplitude relative du signal en fonction du décalage de fréquence par rapport à une porteuse en définissant un spectre à double bande latérale conformément à l'art antérieur ;
Les Figures 5A et 5B montrent, dans le cadre d'un procédé de codage numérique utilisant la modulation de phase à bande latérale unique conformément à l'invention, des courbes montrant d'une part le signal de dérivée de phase généré et d'autre part le signal de phase intégré;
La Figure 6 montre le schéma d'un exemple de dispositif de codage numérique utilisant la modulation de phase à bande latérale unique selon l'invention ;
La Figure 7 montre une courbe donnant la densité spectrale du signal en fonction de la fréquence pour des signaux codés à bande latérale unique conformément à l'invention, avec un incrément de phase exactement égal à 2n ;
Les Figures 8A et 8B représentent des courbes donnant la densité spectrale du signal en fonction de la fréquence pour des signaux codés à bande latérale unique conformément à l'invention, avec un incrément de phase respectivement égal à 0,965 x $2\pi$ et à 0,9123 x $2\pi$;

La Figure 9 montre une courbe donnant la densité spectrale du signal en fonction de la fréquence pour des signaux codés qui ne sont plus à bande latérale unique, du fait que par rapport à la formule ayant conduit à la courbe de la Figure 7, des lorentziennes ont été remplacées par des gaussiennes;

La figure 10 montre le schéma d'un exemple de dispositif de démodulation d'un signal codé en phase à bande latérale unique selon l'invention ;

La Figure 11 montre une courbe donnant la densité spectrale d'un signal codé en phase multi-niveaux qui est moyenné selon un exemple de réalisation de l'invention ;

La Figure 12 montre une courbe donnant la densité spectrale d'un signal codé en phase multi-niveaux qui est obtenu avec une modulation à décalage de phase selon l'art antérieur, le spectre étant de type double bande ;

La figure 13 montre le schéma d'un exemple de dispositif de démodulation de signaux par une base de signaux périodiques orthogonaux, selon l'invention ;

Les Figures 14A à 14E montrent des courbes représentant un signal de départ puis quatre graphes représentant le signal de détection sélective de bits de niveaux 3, 2, 1 et 0 respectivement, dans le cadre d'un procédé de démodulation de signaux par une base de signaux périodiques orthogonaux selon l'invention ;

Les Figures 15A à 15C montrent des courbes représentant d'une part un signal de dérivée en phase ayant servi à générer un signal à détecter et d'autre part un signal de détection des bits de valeur 0 et de valeur 1 dans le cadre d'un procédé de démodulation d'un signal binaire codé en phase selon l'invention;

Les Figures 16A et 16B montrent, pour un procédé d'émission en phase et hors phase de signaux binaires codés en phase à bande latérale unique selon l'invention, respectivement les parties réelles et imaginaires du signal détecté (ou démodulé) pour une série de bits selon un premier exemple de réalisation, la modulation de dérivée de phase du signal codé étant incluse dans chaque graphe;

La Figure 17 montre une courbe donnant la densité spectrale des signaux binaires codés selon en phase à bande latérale unique selon l'invention, tels qu'illustrés sur l'exemple des Figures 16A et 16B ;

Les Figures 18A et 18B montrent, pour un procédé d'émission en phase et hors phase de signaux binaires codés en phase à bande latérale unique selon l'invention, respectivement les parties réelles et imaginaires du signal détecté (ou démodulé) pour une série de bits selon un deuxième exemple de réalisation, la modulation de dérivée de phase du signal codé étant incluse dans chaque graphe;

La Figure 19 montre une courbe donnant la densité spectrale des signaux binaires codés selon en phase à bande latérale unique selon l'invention, tels qu'illustrés sur l'exemple des Figures 18A et 18B ;

Les Figures 20A à 20C représentent des courbes donnant un signal modulé en modulation mixte amplitude-phase à bande latérale unique selon un exemple de réalisation de l'invention, pour des valeurs de l'indice de modulation h respectivement égales à 1, 2 et 3 ; et

La Figure 21 montre le schéma d'un exemple de dispositif de codage numérique utilisant la modulation de phase à bande latérale unique selon l'invention dans le cadre d'une application au domaine optique;

## Description détaillée de modes particuliers de réalisation

L'invention porte sur un procédé de modulation d'ondes. En premier lieu, le procédé permet par une incrémentation temporelle originale de la phase d'une onde porteuse de générer directement un signal dont le spectre de fréquence est à bande latérale unique (BLU), c.à.d. un signal dont le contenu en fréquence est dans un domaine soit supérieur soit inférieur à la fréquence de l'onde porteuse, mais pas les deux à la fois.

En second lieu, en conservant la même forme temporelle de l'incrément de phase mais en le multipliant par un nombre entier, le procédé selon l'invention permet de générer une base originale de signaux temporels orthogonaux entre eux et qui conservent la propriété de BLU.

D'autre part le spectre en fréquence obtenu est très ramassé avec une décroissance exponentielle de la puissance spectrale dans la bande latérale unique.

Le procédé peut s'appliquer à tout type d'ondes, par exemple des ondes électromagnétiques (des plus basses fréquences au domaine optique) ou bien encore des ondes acoustiques.

Une application immédiate concerne le codage physique d'information par modulation de phase pour la transmission de données numériques (par exemple GSM, Bluetooth, Wifi, TV numérique, communications satellites, RFID, etc, ... pour le domaine micro-onde ou par exemple la transmission haut débit pour le domaine optique).

L'invention propose une modulation de forme particulière de la phase d'une onde porteuse qui, seule, est capable de générer un spectre de fréquence à bande latérale unique.

On considère l'ensemble des signaux $s_h(t)$ constitués d'une onde de fréquence porteuse $f_C$ dont la phase $\varphi(t)=h\varphi_0(t)$ est modulée dans le temps $t$: $s_h(t)=\cos(2\pi f_C t+h\varphi_0(t))$ et où $h$ est un entier positif ou nul et où $\varphi_0(t) = 2 \arctan((t-t_0)/w_0)$.

La modulation correspond à une impulsion de phase unique centrée au temps $t_0$ de durée caractéristique $w_0$ (>0) et incrémentant la phase du signal $s_h(t)$ de la quantité $h2\pi$.

Pour faire référence à la terminologie utilisée dans le cadre de transmissions numériques basées sur la modulation de phase, $h$ s'identifie à l'indice de modulation (ou en anglais « modulation index »).

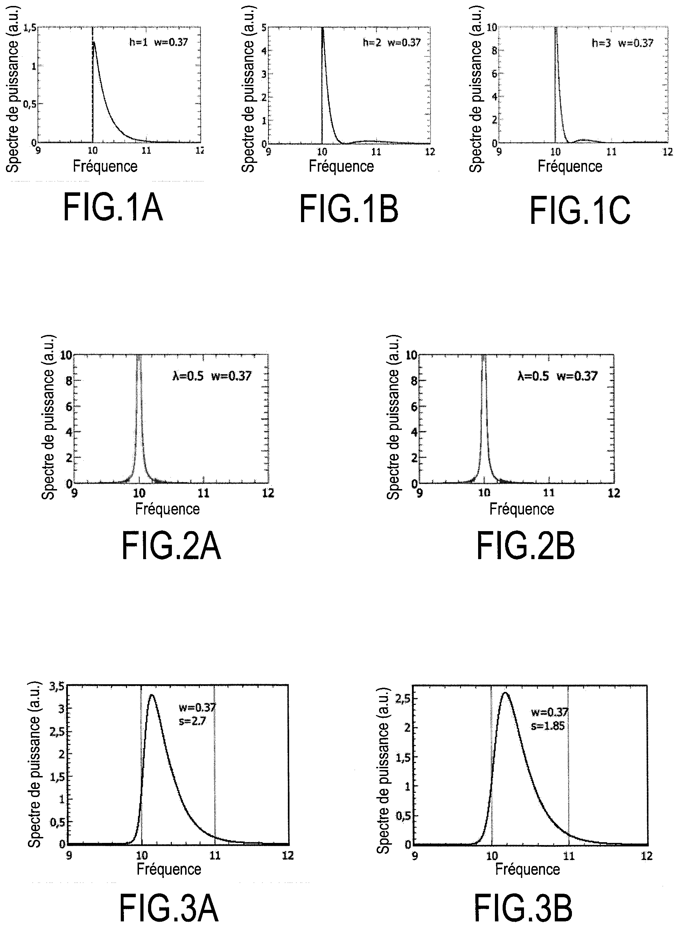

La densité spectrale $P_h(f)=|\tilde{s}_h(f)|^2$ du signal, où $\tilde{s}_h(f)$ est la transformée de Fourier de $s_h(t)$ est représentée sur les figures 1A à 1C pour des valeurs de $h$ respectivement égales à 1, 2 et 3.

On voit que le spectre est à bande latérale unique : le spectre n'a pas de composante dans la bande de fréquence inférieure à $f_C$.

Il est à noter que si l'on avait choisi h<0 on aurait un spectre miroir par rapport à la fréquence porteuse et aucune composante dans la bande supérieure.

Le choix de $t_0$ et de $w_0$ peut être arbitraire mais ne changera pas la propriété de bande latérale unique.

De manière explicite, la densité spectrale est donnée par une exponentielle décroissante multipliée par des polynômes de Laguerre $L_h(_X)$ de degré $h$-1.

$$P_h(f)=\left[L_h(\pi(f-f_C)w)\right]^2 e^{-4\pi(f-f_C)w} \quad si \ f \geq f_C$$

$$P_h(f)=0 \quad si \ f < f_C$$

De façon remarquable, le spectre à bande latérale unique est conservé si la variation de phase est généralisée à la somme d'incréments $\varphi(t)=\sum_i h_i\,\varphi_i(t)$ $\varphi(t)$ où les $h_i$ sont des entiers positifs et $\varphi_i(t) = 2\ \arctan((t-t_i)/w_i)$ avec $w_i >0$ et $t_i$ arbitraires.

La condition d'avoir les entiers $h_i$ tous de même signe ne peut être dérogée pour conserver la propriété de BLU.

La forme $\varphi(t)=\sum_i h_i\,\varphi_i(t)$ sera mise à profit et exploitée plus loin dans les exemples d'applications concernant le transport d'information binaire par codage de phase à bande latérale unique.

On donnera ci-dessous quelques propriétés importantes de la modulation de phase BLU.

- Pour une impulsion de phase unique, seule la forme générique $\varphi_0(t) = 2\ \arctan((t - t_0)/ w_0)$ est capable de générer une bande latérale unique, $t_0$ et $w_0$ étant arbitraires. Toute autre forme de variation temporelle conduira à un spectre à double bande latérale. La propriété BLU est conservée si la phase est une somme d'impulsions de phase de forme similaire à $\varphi_0$ avec une largeur arbitraire, générées à des instants arbitraires et multipliées par un nombre entier positif arbitraire.
- Un spectre à bande latérale unique miroir, par rapport à la fréquence porteuse, est obtenu si le signe de la phase est inversé.
- Le facteur multiplicatif $h$ (plus généralement tous les $h_i$, impérativement de même signe) doit impérativement être entier.
- Les figures 2A et 2B montrent que les spectres obtenus pour des signaux $s_\lambda(t)=cos(2\pi f_C t+\lambda\varphi_0(t))$ où $\cdot\lambda$ (remplaçant $h$) est non-entier ne sont pas à bande latérale unique.
- La multiplication de $\varphi_0$ par un entier positif permet de générer une base de fonctions orthogonales comme cela sera explicité plus loin.

On explicitera ci-dessous des critères de BLU pour des modulations qui, sans constituer une modulation parfaite, approchent la modulation parfaite et par là-même entrent également dans le cadre de la présente invention.

Une modulation dont l'incrément de phase n'est pas multiple de $2\pi$, fait apparaître la seconde bande latérale même si la forme de la modulation est inchangée, c'est à dire une Lorentzienne pour la dérivée de phase. C'est ce qui est clairement apparent sur les figures 2A et 2B.

Pour quantifier le caractère BLU, on peut définir le rapport de la somme de la puissance spectrale pour des fréquences supérieures à la porteuse divisé par la somme de la puissance spectrale totale :

$$c_{BLU} = \int_{f_C}^{\infty} P(f)/\int_{-\infty}^{\infty} P(f) \ \cdot$$

Dans les figures 2A et 2B, pour une modulation avec respectivement $\lambda$ = 0,5 et 1,5 on trouve $C_{BLU}$ = 56,9% et 61,7% respectivement, c'est-à-dire des spectres très éloignés de ceux attendus pour une bande latérale unique ($C_{BLU}$ = 100%).

Dans certains exemples d'application, la variation de la phase $\varphi_0(t) = 2 \arctan((t - t_0) / w_0)$ peut être considérée comme trop lente pour rejoindre la valeur $2\pi$. En effet: $\varphi_0(t) \approx \pi - \pi w/t,\ t \to \infty$.

Il peut être utile de définir une forme approchée de $\varphi_0(t)$ dans laquelle la partie lente est tronquée. C'est ce qui sera fait dans l'exemple considéré pour une application à une modulation mixte amplitude-phase à bande latérale unique.

On multiplie la Lorentzienne $d\varphi_0(t) / dt$ par une Gaussienne de largeur $s$. La dérivée de la phase approchée, notée $\varphi_{0,s}(t)$ est alors $d\varphi_{0,s}(t)/dt = \mu \exp(-t^2 / 2s^2) 2w / (t^2 + w^2)$ où le paramètre $\mu$ est un coefficient multiplicateur qui permet de conserver un incrément de phase total égal à $2n$. La puissance spectrale de $s(t) = \cos(2\pi f_C t + \varphi_{0,s}(t))$ est montrée sur les figures 3A et 3B pour une Lorentzienne de largeur $w=0,37$ et pour deux largeurs de Gaussienne $s=2,7$ et $1,85$ ($\mu \cdot = 1,112$ et $1,165$ respectivement).

Comme la dérivée de la phase diffère maintenant d'une Lorentzienne, une bande latérale inférieure apparaît. Cependant les valeurs de s>>w permettent de conserver un caractère de BLU proche de 100% ($C_{BLU} = 95,9\%$ et $95\%$ respectivement).

On décrira maintenant un exemple d'application de la présente invention au transport d'une information binaire par codage de phase à bande latérale unique.

On a rappelé plus haut, en référence à la figure 4, des procédés connus de codage de phase, qui donnent tous un spectre à double bande latérale.

On décrira ci-dessous en application de la présente invention, le principe du codage numérique utilisant la modulation de phase à bande latérale unique :
Comme application de la présente invention, on considère le codage suivant de la phase : le $k^{ième}$ bit de durée $T_b$ contribue à la phase totale $\varphi(t)$ de la porteuse par la quantité $2\ b_k \arctan((t-kT_b)/ w)$ où $b_k = 1$ ou $0$ et la largeur $w$ est comparable ou plus petite que la durée du symbole $T_b$.

En pratique il est plus simple de considérer la dérivée de la phase. Celle-ci est alors une somme de Lorentziennes $2w/((t-kT_b)^2 + w^2)$ centrées en $k\ T_b$ et pondérées par le bit $b_k$.

La figure 5A montre le signal de dérivée de phase généré. La phase est ensuite intégrée, comme montré sur la figure 5B, puis adjointe à la porteuse suivant un procédé classique de modulation de phase.

Les quantités $\cos \varphi(t)$ et $\sin \varphi(t)$ sont calculées et combinées aux amplitudes en phase $\cos 2\pi f_C t$ et en quadrature $\sin 2\pi f_C t$ de la porteuse pour obtenir le signal à transmettre :

$$s(t) = \cos(2\pi f_C t + \varphi(t)) = \cos(2\pi f_C t)\cos\varphi(t) - \sin(2\pi f_C t)\sin\varphi(t)\ .$$

Un schéma de principe d'un dispositif permettant d'effectuer un tel codage numérique est fourni sur la figure 6.

Sur la figure 6, on voit un module 101 de fourniture des données $b_k = 1$ ou $0$, un générateur 102 de lorentzienne, un module 103 de génération de phase, un module 104 d'intégration de phase, des modules 105 et 106 de génération respectivement des quantités $\cos \varphi(t)$ et $\sin \varphi(t)$, un générateur 107 de fréquence porteuse, un module 108 de déphasage, des circuits mélangeurs 109, 110 et un circuit additionneur 111 de manière à combiner les quantités $\cos \varphi(t)$ et $\sin \varphi(t)$ aux amplitudes en phase $\cos 2\pi f_C t$ et en quadrature $\sin 2\pi f_C t$ de la porteuse pour obtenir le signal à transmettre : $s(t)=\cos(2\pi f_C t+\varphi(t)) = \cos(2\pi f_C t)\cos\varphi(t)-\sin(2\pi f_C t)\sin\varphi(t)$. Un amplificateur de sortie 112 est relié à une antenne d'émission 113.

On considèrera maintenant le spectre des signaux codés en phase à bande latérale unique.

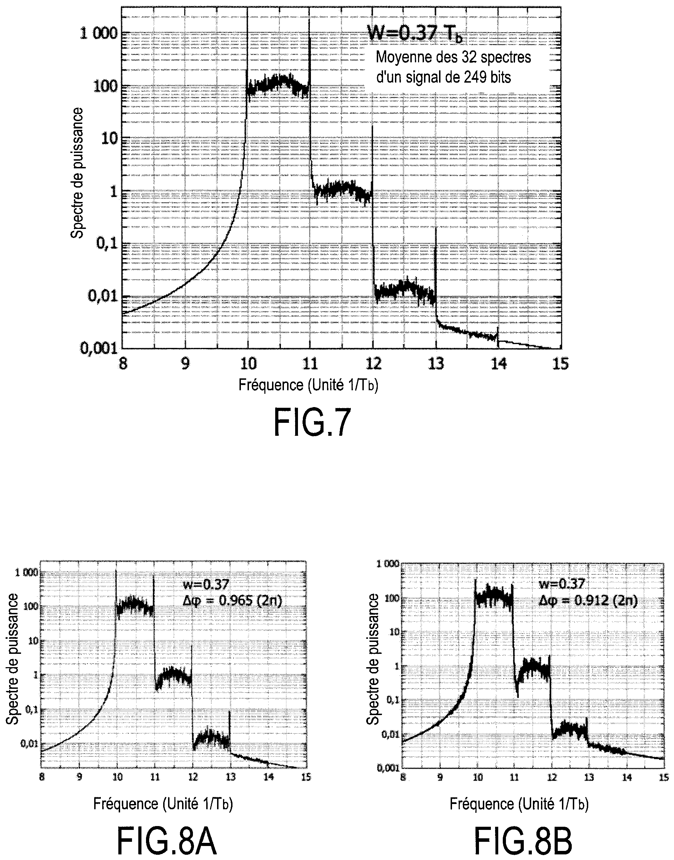

La puissance spectrale du signal est représentée sur la figure 7 pour une largeur d'impulsion telle que $w/T_b =0,37$. Les fréquences sont en unité de $1/T_b$. La porteuse a une fréquence égale à $10/T_b$. Le choix d'une autre fréquence porteuse donnerait un spectre à BLU similaire autour de celle-ci.

Le spectre montre clairement la propriété de bande latérale unique. A gauche de la fréquence porteuse, le spectre décroît extrêmement rapidement, sa valeur finie n'étant due qu'à des effets de taille finie. A droite de la fréquence porteuse, la puissance spectrale décroit de manière abrupte de 20dB à la fréquence $f_C + 1/T_b$, puis de 20dB encore à la fréquence $f_C + 2/T_b$ et ainsi de suite.

Le tassement de la décroissance à plus haute fréquence est à mettre sur le compte du calcul qui comporte un nombre d'échantillons finis (moyenne de 32 spectres correspondant à des tirages indépendants d'une série aléatoires de 259 bits de durée $T_b$).

Si on fait le choix d'une plus petite largeur $w/T_b$ les composantes de Fourier s'étendront à plus haute fréquence. En effet la puissance décroit exponentiellement de $e^{-4\pi w/T_b}$ pour un accroissement en fréquence de $1/T_b$, c.à.d. 1/100 (-20dB) pour $w/T_b =0,37$.

On observe aussi sur le spectre des pics fins, appelés lignes spectrales, centrés aux fréquences $f_C, f_C +1/T_b$, $f_C +2/T_b$, etc,. Ils sont dus au choix d'un incrément de phase exactement égal à $2\pi$. Cet effet a déjà été noté pour des procédés conventionnels de modulations de phase dont l'incrément est $2\pi$, comme indiqué dans l'article de H. E. Rowe and V. K. Prabhu, intitulé « Power spectrum of a digital, frequency-modulation signal », paru dans The Bell System Technical Journal, 54, No 6, pages 1095-1125 (1975).

Dans le présent procédé, il est important de ne pas s'écarter de cette valeur car cela conduirait à la réapparition d'une bande latérale inférieure du spectre.

Toutefois, en pratique, cette bande latérale inférieure du spectre reste négligeable si l'incrément est de quelques % inférieur ou supérieur à $2\pi$ tandis que les pics fins du spectre sont réduits, voire supprimés. C'est ce que montre la figure 8A pour un spectre dont l'incrément de phase est $0,965 \times 2\pi$. La diminution des pics fins s'accompagne d'une partie bruitée de la courbe pour des fréquences entre 9,5 et 10 attestant l'apparition d'une contribution faible mais non nulle dans la bande latérale inférieure. Pour un incrément de phase $0,9123 \times 2\pi$ le phénomène est un peu plus marqué (voir la figure 8B). Pour un incrément de phase inférieur à $0,9$ $(2\pi)$ ou supérieur à $1,1$ $(2\pi)$, on considérera que le caractère BLU est perdu.

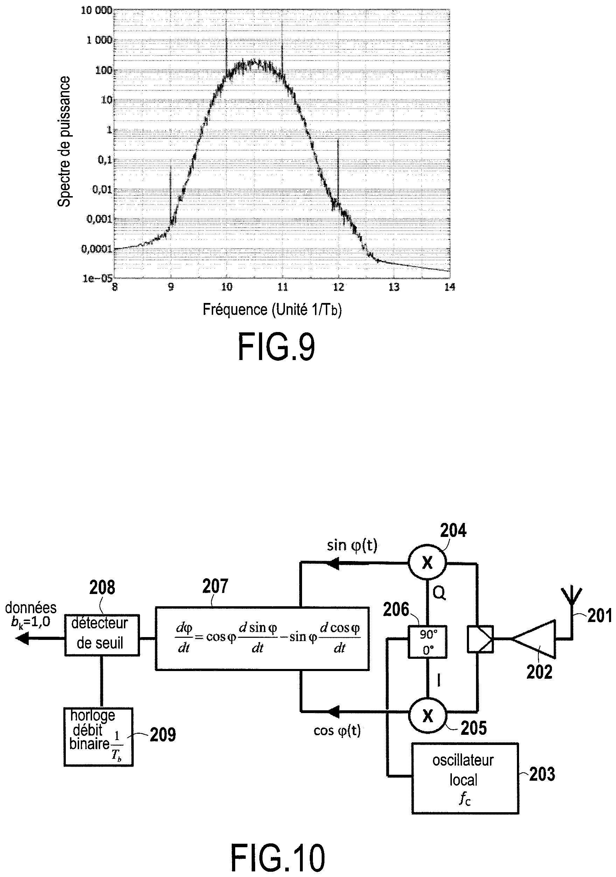

Finalement la figure 9 montre le spectre obtenu si on remplace dans $d\varphi/dt$ les Lorentziennes par des Gaussiennes (en conservant le même incrément de phase et pour une largeur d'impulsion comparable). La différence de spectre est frappante. La présence d'une bande latérale inférieure est très marquée.

On décrira maintenant, en référence à la figure 10, un exemple de procédé et de dispositif de démodulation du signal codé en phase à bande latérale unique, conformément à l'invention.

A la réception, par une antenne 201 et un amplificateur 202, la première étape de démodulation pour extraire le signal de la porteuse est classique. Un oscillateur local 203 de fréquence $f_C$ associé à des mélangeurs 204, 205, à un déphaseur 206 de 0°- 90° permet d'obtenir les composantes en phase et en quadrature $\cos(\varphi(t))$ et $\sin(\varphi(t))$ du signal de modulation. En dérivant celles-ci et les multipliant par leur partenaire dans un module de calcul 207 on retrouve la dérivée de la phase $d\varphi/dt = \cos\varphi(t)\, d(\sin\varphi(t))/dt - \sin\varphi(t)d(\cos\varphi(t))/dt$.

Ceci permet de reconstituer la série d'impulsions Lorentziennes initialement générées comme celles de la figure 5A. En plaçant un détecteur de seuil 208 à une valeur moitié de l'amplitude d'une Lorentzienne unique la valeur d'un bit $b_k = 1$ ou $0$ au temps $t_k = kT_b$ est facilement discriminée. Une horloge 209 fournit au détecteur de seuil 208 des impulsions à un rythme de $1/T_b$.

Dans la pratique, au signal détecté s'ajoute le bruit de détection. Dériver un signal, ici $\sin\varphi$ et $\cos\varphi$, a pour effet d'augmenter l'effet du bruit. Un autre moyen de démodulation qui ne fait pas appel à une dérivation peut être utilisé, comme cela sera décrit plus loin, en référence à la propriété d'orthogonalité des impulsions de phase à bande latérale unique.

On décrira maintenant un procédé de génération de signaux orthogonaux à bande latérale unique.

Il s'agit de générer un ensemble de fonctions orthogonales $u_h(t)$, $h = 1,2,3, ...,N$ sur la durée finie $T_b$ pour leur exploitation par exemple en transmission de données avec le débit $1/T_b$ par canal d'information.

Pour construire ces fonctions orthogonales, il est utile de considérer d'abord le cas où $T_b$ est infini (impulsion unique).

$$u_h(t) = \frac{1}{\sqrt{2\pi}} e^{ih\,\varphi_0(t)} \sqrt{\frac{d\varphi_0(t)}{dt}} = \frac{1}{\sqrt{2\pi}} \frac{(t+iw)^{h-1}}{(t-iw)^h}$$

où on

La base de fonctions orthogonales est alors : a utilisé la phase $\varphi_0(t) = 2\arctan(t/w)$ définie plus haut.

Par choix de simplicité, les fonctions sont centrées en $t=0$. On peut vérifier que $\displaystyle\int_{-\infty}^{+\infty} u_{h'}^*(t) u_h(t)dt = \delta_{h,h'}$.

$$s_h(t) = e^{ih\,\varphi_0(t)} = \frac{(t+iw)^h}{(t-iw)^h}$$

En pratique il pourra être plus intéressant de considérer les signaux $s_h(t)$ puis d'assurer la séparation par orthogonalité de deux signaux $s_h(t)$ et $s_{h'}(t)$ en effectuant l'intégration :

$$\frac{1}{2\pi}\int_{-\infty}^{+\infty} s_{h'}^*(t) s_h(t)\frac{d\varphi_0}{dt} dt = \delta_{h,h'} \qquad \frac{d\varphi_0}{dt} = 2w/(t^2 + w^2)$$

apparaît comme un poids (ou mesure) pour l'intégration.

Avec cette définition, les signaux $s_h(t)$ sont à amplitude constante (de module unité) ce qui peut présenter un avantage pratique pour leur génération (puissance d'émission constante). Le spectre des $s_h(t)$ est à bande latérale unique.

La généralisation à des fonctions orthogonales sur un intervalle non plus infini mais fini $T_b$ s'obtient en considérant la série périodique d'impulsions de phase espacées de la durée $T_b$. Cela donne les signaux périodiques

$$s_h(t) = e^{ih\,\varphi_0(t,T_b)} = \left(\frac{\sin\left(\pi(t+iw)/T_b\right)}{\sin\left(\pi(t-iw)/T_b\right)}\right)^h .$$

La dérivée de la phase $\varphi_0$ est une somme périodique de Lorentziennes.

Cette somme peut se réécrire sous la forme d'une fonction périodique :

$$\frac{d\varphi_0}{dt} = \frac{\pi}{T_b} \cdot \frac{sh(2\pi w/T_b)}{\sin^2(\pi t/T_b) + sh^2(\pi w/T_b)} \; .$$

Deux signaux différents par les entiers $h$ et $h'$ vérifient une relation d'orthogonalité sur l'intervalle de temps

$$T_b : \frac{1}{2\pi} \int_{-T_b/2}^{+T_b/2} s_{h'}^*(t) \, s_h(t) \frac{d\varphi_0}{dt} dt = \delta_{h,h'} \qquad \frac{d\varphi_0}{dt}$$ où là encore $\frac{d\varphi_0}{dt}$ joue le rôle de poids pour l'intégration.

En pratique $\frac{d\varphi_0}{dt}$ est calculé (ou généré) puis intégré pour donner $\varphi_0(t,T_b)$ puis $s_h(t)=e^{ih\varphi_0(t,T_b)}$ est synthétisé. On voit qu'une simple multiplication de la phase par un nombre entier permet d'obtenir un jeu de signaux d'amplitude constante présentant le caractère d'orthogonalité. D'autre part le spectre, maintenant discret, conserve la propriété de bande latérale unique.

On donnera maintenant un exemple d'application à la détection de signaux numériques multi-niveaux codés en phase.

On considèrera d'abord le choix du codage de phase multi-niveaux.

Il s'agit de coder 2 bits sur quatre niveaux comme par exemple le procédé de modulation d'amplitude 2B1Q (« 2Binary-1Quaternary ») mais ici transposé en modulation de la phase.

On peut bien sûr généraliser à N-niveaux (N-ary bits) avec $h = 0,1,..., N - 1$ et $N = 2^p$ Le débit en bits par seconde n'est plus $1/T_b$ comme plus haut mais devient alors $p/T_b$.

On pourrait choisir un codage de la phase $\varphi(t) = \sum_k b_k \, \varphi_0(t - kT_b, T_b)$ où le bit $b_k$ vaut $b_k = 0,1,2,3$ (pour respectivement 00, 01, 10 et 11) et est défini dans l'intervalle $(k-1/2)T_b \leq t < (k+1/2)T_b$.

Ainsi, on pourrait exploiter pleinement l'orthogonalité des signaux $s_{bk}(t-kt_b)=e^{ib_k\varphi_0(t-kT_b,T_b)}$ sur chaque intervalle $[k-1/2,k+1/2]T_b$ pour retrouver la valeur du bit quaternaire $b_k$ à la démodulation. C'est une application possible de la présente invention.

Cependant pour deux bit consécutifs $b_k$ et $b_{k+1}$ de valeurs différentes, il y a une discontinuité de la dérivée de la phase égale à $(b_{k+1}-b_k)d\varphi_0(T_b/2,T_b)/dt$. Les discontinuités vont générer des queues de spectres décroissant lentement. Dans l'exemple d'application choisi ici, on fait le choix de privilégier la compacité du spectre au prix d'une moins bonne exploitation de la propriété d'orthogonalité. Pour cela la phase est codée comme indiqué plus haut avec

$$\varphi(t) = \sum_k b_k \, \varphi_0(t - kT_b)$$
$\varphi_0(t) = \varphi_0(t, T_b=\infty) = 2 \arctan(t/w)$ et $b_k = 0,1,2,3$.

La dérivée de la phase est donc une somme de Lorentziennes dont l'amplitude prend aléatoirement quatre niveaux de valeur. Ce codage assure l'absence de discontinuité de la phase. Cependant, les signaux $e^{ih\varphi_0(t)}$ ne vérifient pas de relations d'orthogonalité avec les fonctions $e^{ih'\varphi_0(t,T_b)}$ qui seront utilisées pour retrouver par démodulation les $b_k$, mais ils vérifient seulement des relations d'orthogonalité approchées. La démodulation reste néanmoins efficace en pratique.

Le schéma de principe pour l'émission de données est similaire à celui des figure 5A et 5B, mais où les bits binaires 0 ,1 sont remplacés par les bits quaternaires $b_k = 0,1,2,3$.

On décrira maintenant le spectre du signal codé en phase multi-niveaux.

Comme exemple d'application proposé, on considère le spectre d'un signal composé d'une suite de 33 bits quaternaires (« Quaternary ») de durée $T_b$. Le signal généré est : $s(t)=\cos(2\pi f_C t+\varphi(t))$ où $\varphi(t) = \sum_{k=-16}^{+16} b_k \, \varphi_0(t - kT_b) \; .$

Les bits quaternaires $b_k=0, 1, 2$, ou 3 (correspondant aux bits binaires 00, 01, 10, 11) sont choisis en utilisant un générateur de nombres pseudo-aléatoires pour représenter une séquence de données. Le débit est $2/T_b$ bits par seconde. La fréquence de la porteuse est choisie comme $f_C= 10/T_b$ et la largeur $w=0,3\,T_b$.

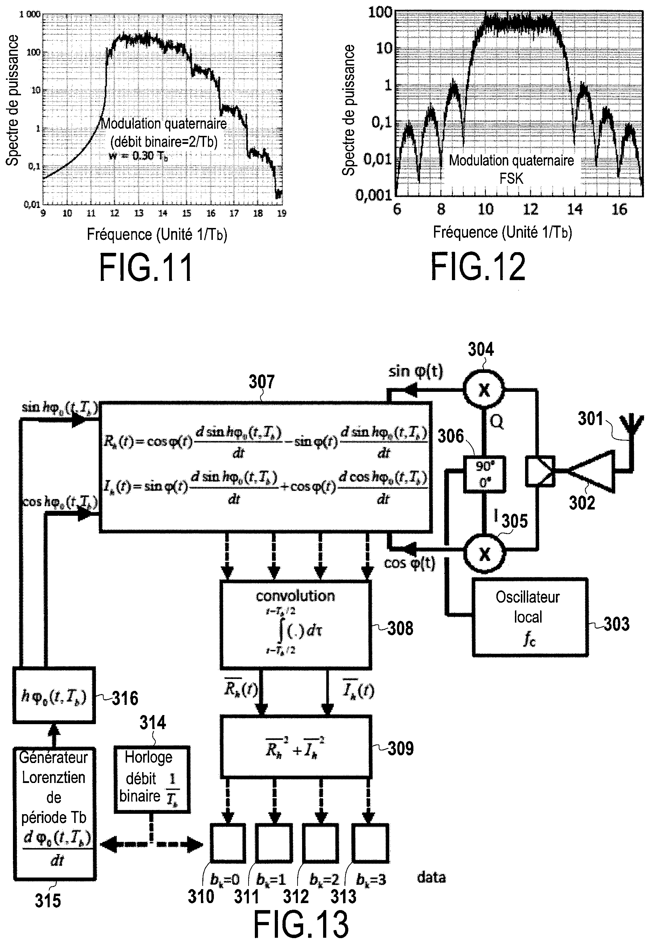

La figure 11 montre le spectre en fréquence moyenné correspondant à 32 séquences de bits quaternaires différentes.

Le caractère à bande latérale unique du spectre est bien vérifié. Le spectre ne comporte pas de composante significative pour des fréquences inférieures à la fréquence de porteuse moyenne $\langle f \rangle = f_C + \langle b_k \rangle / T_b = 11.5/T_b$.

Pour des fréquences supérieures à $\langle f \rangle + 2/T_b$, le spectre décroit rapidement exponentiellement, environ 10dB tous les $1/T_b$ (20db pour un accroissement de fréquence égal au bit rate $2/T_b$). Une largeur w plus importante donnerait une décroissance exponentielle encore plus rapide.

Par comparaison le graphe suivant, illustré sur la figure 12, est le résultat d'une modulation de type par déplacement de fréquence (ou en anglais de type Frequency Shift Keying (FSK)), où la fréquence est modulée sur quatre

$$d\varphi(t)/dt = 2\pi \sum_k b_k (1/T_b) \; ).$$

niveaux (c.à.d.

On voit que, pour cette réalisation ne faisant pas partie de la présente invention, autour de la fréquence de porteuse moyenne $\langle f \rangle = f_C + \langle b_k \rangle / T_b = 11.5/T_b$, le spectre est de type double bande. Sa largeur principale est $2/T_b$ mais le spectre est flanqué de queues de spectre décroissant lentement et non exponentiellement.

On décrira maintenant un procédé et un dispositif de démodulation des signaux par une base de signaux périodiques orthogonaux.

A la réception, la première étape de démodulation pour extraire le signal de la porteuse est classique et similaire à l'exemple donné plus haut en référence à la figure 10. Le signal reçu par une antenne 301 est amplifié dans un amplificateur 302. Un oscillateur local 303 de fréquence $f_C$ associé à des mélangeurs 304, 305 et à un déphaseur 306 de 0°- 90° permet d'obtenir les composantes en phase et en quadrature $\cos(\varphi(t))$ et $\sin(\varphi(t))$ du signal de modulation. Selon un premier mode de réalisation, on pourrait suivre le même schéma que sur la figure 10 et obtenir la dérivée de la phase du signal modulé. Cependant, une détection des quatre niveaux d'amplitude (incluant l'amplitude nulle) paraît difficile à cause du recouvrement entre les Lorentziennes d'amplitude différente émises à des instants voisins.

Aussi, une solution préférentielle est d'utiliser la base de signaux orthogonaux périodiques

$$s_h(t) = e^{ih\, \varphi_0(t,T_b)} = \left( \frac{\sin(\pi(t+iw)/T_b)}{\sin(\pi(t-iw)/T_b)} \right)^h \; .$$

En pratique, on réalise la détection séparée des quatre niveaux $h$=0, 1, 2 et 3 des bits quaternaires. Ceci est réalisé en formant par un moyen de démodulation adapté référencé 307 sur la figure 13, les quatre quantités

$$R_h(t) = \left(\cos(\varphi(t) - h\varphi_0(t, T_b))\right)\frac{d\varphi_0}{dt} \quad \text{et} \quad I_h(t) = \left(\sin(\varphi(t) - h\varphi_0(t, T_b))\right)\frac{d\varphi_0}{dt} \quad \text{puis en effectuant dans un}$$

$$\overline{R_h}(t) = \int\limits_{t-T_b/2}^{t+T_b/2} R_h(t-\tau)d\tau$$

module 308 la convolution avec une fonction porte de largeur en temps $T_b$ donnant $\qquad$ et

$$\overline{I_h}(t) = \int\limits_{t-T_b/2}^{t+T_b/2} I_h(t-\tau)dt \; .$$

Ensuite, dans un module 309, on calcule la quantité $\overline{R_h}(t)^2 + \overline{I_h}(t)^2$. Un pic observé dans cette quantité (qui constitue un signal de détection de niveau de bit h ou en anglais un « bit level h detection signal ») à un instant $t = kT_b$ pour le niveau $h$=0, 1, 2 ou bien 3 signale que le bit $b_k$ vaut $h$.

On dispose ainsi quatre détecteurs de seuil 310 à 313 pour les niveaux h=0, 1, 2 et 3 respectivement.

Une horloge 314 permet de délivrer des impulsions à une cadence de $1/T_b$.

La figure 13 montre encore un générateur de fonctions lorentziennes périodiques de période $T_b$ et un module de calcul 316 permettant de fournir au module 307 les valeurs $\sin(h\varphi_0(t,T_b))$ et $\cosh\varphi_0(t,T_b))$.

$$d\varphi/dt = \sum\limits_{k=-16}^{+16} b_k \, d\varphi_0(t-kT_b)/dt$$

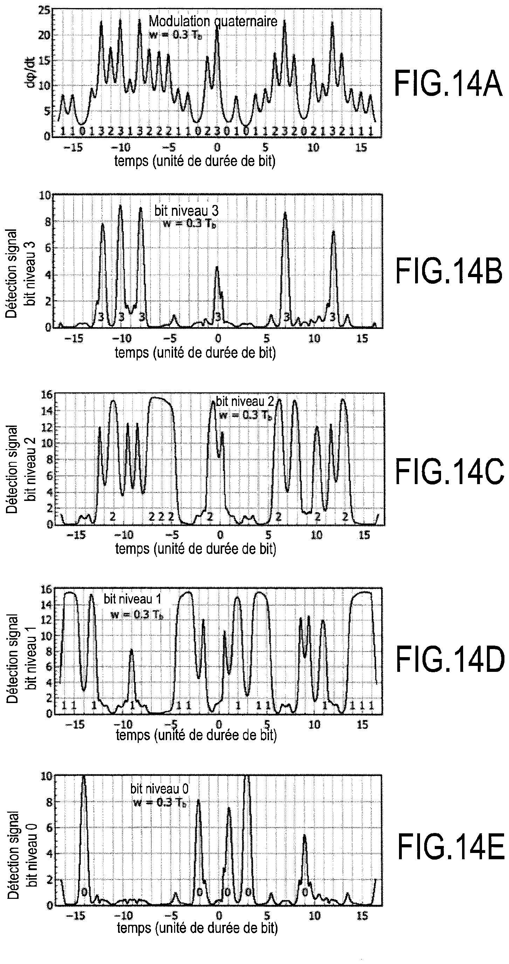

Les figures 14A à 14E montrent, de bas en haut, le signal de départ (Figure 14A), puis quatre graphes représentant le signal de détection sélective des bits de niveau h=3, 2, 1 et 0 (Figures 14B à 14E).

L'information à considérer pour un bit multi-niveau $b_k$ est donnée par la valeur des signaux de détection pris à exactement $t = kT_b$. Par exemple, pour k=-8, le niveau du signal détecté pour h=3 (Figure 14B) prend une valeur importante et montre un pic, tandis que pour les graphes correspondant à h=0, 1 et 2 (Figures 14E, 14D et 14C), le niveau du signal est faible : le bit $b_{k=-8}$ vaut donc 3 (ou 11). Pour les niveaux h=1 et 2 (Figures 14D et 14C), on trouve aussi quelquefois des valeurs significatives pour $t/T_b$ entier qui ne correspond pas à des pics mais à des creux et ne sont pas à considérer pour identifier la valeur de $b_k$. Par exemple pour k=-2, $b_k$ =0 est identifié par un pic pour le signal de détection avec h=0 (Figure 14E), tandis que la valeur du signal de détection avec h=1 (Figure 14D) donne une valeur non nulle mais associée à un creux.

Malgré le grand recouvrement des Lorentziennes, on voit que la méthode consistant à projeter le signal sur la base de signaux périodiques permet un tri sélectif des bits suivant leur niveau et est très efficace.

On considèrera à nouveau la démodulation du signal binaire codé en phase tel que donné plus haut à titre d'exemple.

Comme signalé plus haut, la reconstitution de la dérivée en phase peut ne pas être efficace pour le cas de signaux détectés bruités. La méthode de démodulation utilisant la propriété d'orthogonalité, comme expliquée plus haut pour des bits quaternaires, est préférable et s'applique également et plus efficacement encore pour un signal binaire.

Comme précédemment, la détection consiste à calculer :

$$\left(\int_{t-T_b/2}^{t+T_b/2}\cos(\varphi(t)-h\varphi_0(t,T_b))d\varphi_0/dt\right)^2 + \left(\int_{t-T_b/2}^{t+T_b/2}\sin(\varphi(t)-h\varphi_0(t,T_b))d\varphi_0/dt\right)^2$$

$$\varphi(t)=\sum_{k=-16}^{+16}b_k\,\varphi_0(t-kT_b)\,.$$

où maintenant h=1 ou 0 et

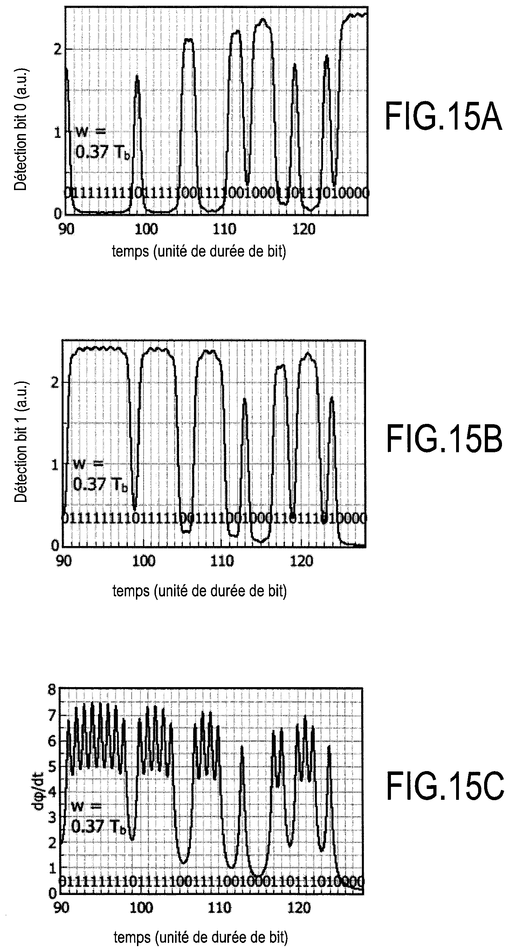

Là encore, $\varphi_0(t)$ ne vérifie pas une relation d'orthogonalité avec $\varphi_0(t,Tb)$ mais le recouvrement est suffisant pour une démodulation efficace. Les figures 15A à 15C montrent, pour les 38 derniers bits de la séquence de 259 bits montrée en figure 4, le signal de détection des bits de valeur 0 (figure 15A) et de valeur 1 (figure 15B). La figure 15C rappelle le signal de dérivée en phase ayant servi à générer le signal à détecter.

La présente invention se prête à diverses autres applications et notamment à l'émission en phase et hors phase de signaux binaires codés en phase à bande latérale unique:

Dans cette application, il est proposé d'exploiter la possibilité de moduler indépendamment la composante en phase et la composante en quadrature de la porteuse afin de doubler le débit d'information (c.à.d. d'avoir un débit binaire ou « bit rate » égal au double du débit symbolique ou « symbol rate »).

Dans les exemples précédents, les signaux étaient à puissance (ou à amplitude) constante avec

$$\varphi(t)=\sum_k b_k\,\varphi_0(t-kT_b)\,.$$

$s(t)=\cos(2nf_Ct+\varphi(t))$ et

Dans le cas présent, le signal étant la somme de deux amplitudes ne sera plus à amplitude constante :

$$s(t)=\cos(2\pi f_Ct+\varphi_1(t)) + \sin(2\pi f_Ct+\varphi_2(t))$$

Ici $\varphi_1(t)=\sum_k b_{k,1}\,\varphi_0(t-kT_b)$ et $\varphi_2(t)=\sum_k b_{k,2}\,\varphi_0(t-kT_b)$ où on a utilisé deux jeux de bits indépendants $b_{k,1(2)}$ pour doubler le débit.

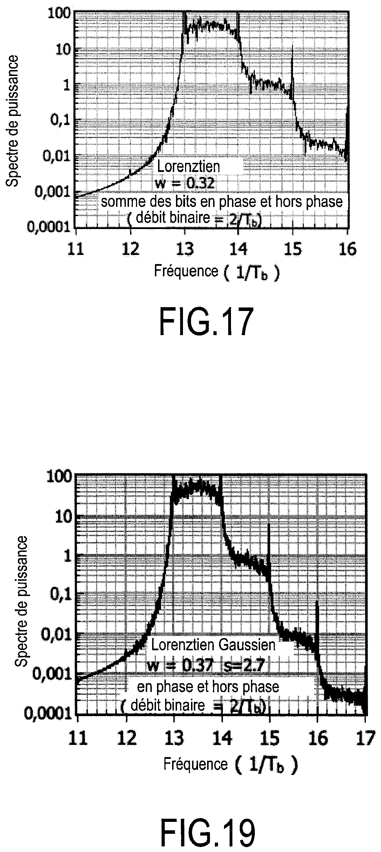

Le spectre de chacune des amplitudes hors phase et en phase étant à BLU, le signal total présente encore la propriété de BLU (voir les figures 17 et 19).

On discute dans ce qui suit la procédure pour retrouver l'information sur les bits émis lors de la démodulation.

On se restreint pour simplifier au cas de bits binaires. Pour une bonne démodulation, on montre que les variations de phase relatives de $\varphi_1(t)$ et $\varphi_2(t)$ doivent rester petites. Ces variations proviennent de l'interférence (recouvrement) entre les impulsions de phase adjacentes (encore dénommée « Inter-Symbol Interférence » ou « ISI »), une contrainte qui était non-pertinente dans l'exemple des figures 3A et 3B.

A la démodulation de la porteuse, on obtient la partie en phase et hors phase, soit respectivement :

$$\mathrm{Re}(t)=\cos(\varphi_1(t)) - \sin(\varphi_2(t))$$

$$\mathrm{Im}(t)=\sin(\varphi_1(t)) + \cos(\varphi_2(t))$$

Dans le cas où w<<$T_b$ (pas d'ISI), pour t=k$T_b$ on a Re(k$T_b$)=cos($b_{k,1}\pi$)-sin($b_{k,2}\pi$) soit 1 ou -1 pour $b_{k,1}$=0 ou 1 respectivement et indépendamment de la valeur de $b_{k,2}$.

De même, on a : Im(k$T_b$)=sin($b_{k,1}\pi$)+cos($b_{k,2}\pi$) soit 1 ou -1 pour $b_{k,2}$=0 ou 1 respectivement, indépendamment de la valeur de $b_{k,1}$.

$R_e$ donne l'information sur le premier jeu de bits et $I_m$ celle sur le second jeu de bits. Dans le cas ou w/$T_b$ est

$$\theta_1 = \sum_{k' \neq k} b_{k,1}\, \varphi_0((k'-k)T_b)$$

plus grand une phase supplémentaire $\theta_1 = \sum_{k' \neq k} b_{k,1} \varphi_0((k'-k)T_b)$ s'additionne à la phase attendue en $T_b$ $\varphi_1(kT_b)=b_{k,1}\pi+\theta_1$. De manière similaire, une phase $\theta_2$ affecte $\cdot\varphi_2$. On a alors :

$$\mathrm{Re}(kT_b) = \cos(b_{k,1}\pi + \theta_1) - \sin(\theta_2)$$

$$\mathrm{Im}(kT_b) = \sin(\theta_1) + \cos(b_{k,2}\pi + \theta_2)$$

Il faut avoir impérativement $|\theta_1| \ll \pi/4$ et $|\theta_2| \ll \pi/4$ pour retrouver sans erreur chacun des bits émis au temps $kT_b$. (c.à.d. afin que Re et Im soient toujours de valeur significativement positive (bit 0) ou négative (bit 1) mais jamais proches de zéro).

Si par un filtrage temporel de d$\varphi$/dt on limite l'ISI aux bits émis aux temps compris entre $(k\pm N)T_b$ ou aura $|\theta_{1,2}|^{\mathrm{MAX}} \approx (\gamma+\ln(N)w/T_b \ll \pi/4$, où $\gamma$=0,577... est la constante d'Euler. Cela donne pratiquement N<<4,7 pour w/$T_b$=0,37 , N<<6,5 pour w/$T_b$=0,32 et N<<39 pour w/$T_b$=0,185. Dans tous les cas un filtrage temporel limitant l'interférence entre impulsions de phase adjacentes est nécessaire.

Des exemples sont donnés ci-dessous.

Une façon de limiter l'ISI est d'utiliser pour la dérivée de la phase une Lorentzienne-Gaussienne comme indiqué plus haut en référence aux figures 3A et 3B, avec l'impulsion de phase élémentaire obtenue par intégration de $d\varphi_{0,s}(t)/dt$ = $\mu$ exp(-$t^2$/ 2$s^2$)2w/($t^2$+ $w^2$) où le paramètre $\mu$ est un coefficient qui permet de conserver un incrément de phase total égal à 2n.

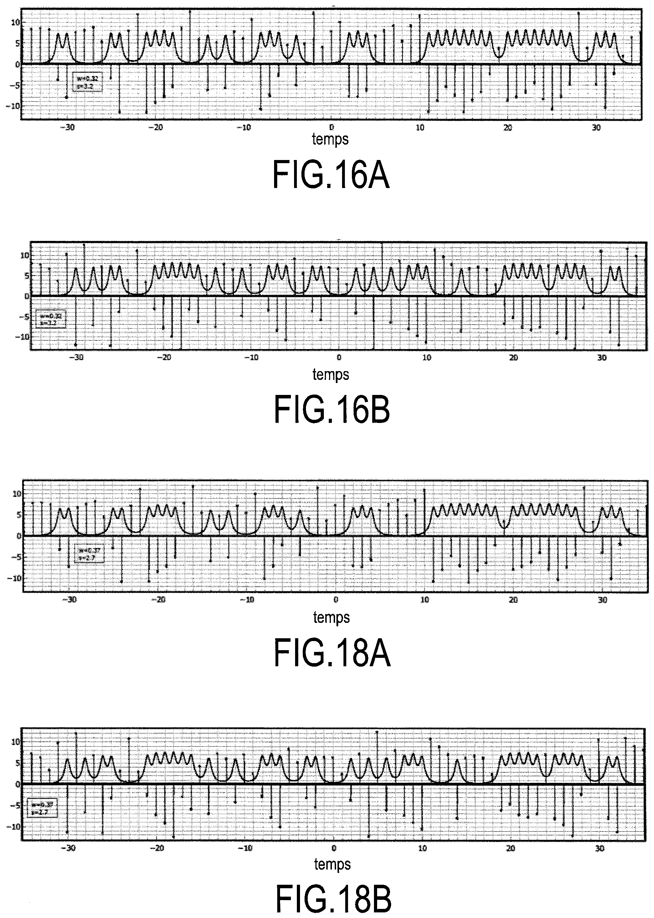

Les figures 16A et 16B montrent en unité arbitraire les signaux Re (figure 16A) et Im (figure 16B) pour une série de bits avec w/$T_b$ =0,32 et s/$T_b$ =3,2 ($\cdot\mu$=1,0811) ainsi que $$d\varphi_1(t)/dt = \sum_k b_{k,1}\, d\varphi_{0,s}/dt$$ et

$$d\varphi_2(t)/dt = \sum_k b_{k,2}\, d\varphi_{0,s}/dt$$

Le spectre en fréquence correspondant pour une fréquence de porteuse $f_C$ =13 (unités 1/$T_b$) est montré sur la figure 17.

Le caractère BLU est bien conservé à part une faible composante de spectre dans la bande inférieure puisque la dérivée de phase élémentaire n'est plus strictement une Lorentzienne. On voit que plus de 90% du spectre est concentré dans une bande de fréquence 1/$T_b$ soit la moitié du débit binaire (« bit rate »).

L'exemple suivant montre qu'on peut atteindre 98% du spectre dans une bande de fréquence égale à la moitié du débit binaire (bit rate) avec les paramètres : w/$T_b$ =0,37 et s/$T_b$ =2,7 ($\cdot\mu$=1,112). Les figures 18A et 18B montrent les signaux Re (figure 18A) et Im (figure 18B) et la figure 19 montre le spectre.

Ces deux exemples montrent qu'une efficacité spectrale (rapport du débit binaire sur la largeur spectrale) très élevée ~2 bit/s/Hz peut être obtenue avec un spectre à BLU très ramassé.

On décrira maintenant une application à une modulation mixte amplitude-phase à bande latérale unique : Une application directe de la présente invention consiste à moduler le signal de la porteuse à la fois en amplitude et en phase.

Dans ce qui précède, on a considéré uniquement une modulation de la phase $\varphi$(t). Le principe est de gérer une impulsion du signal, c.à.d. un signal démarrant puis retournant à zéro. Pour une impulsion unique centrée en $t_0$ et de largeur $w_0$ et pour l'impulsion élémentaire de phase $\varphi$(t) =$\varphi_0$(t) = 2 arctan(($t$-$t_0$)/$w_0$) :

$$s(t) = \cos(2\pi f_C t) + \cos(2\pi f_C t + \varphi_a(t))$$

Le signal peut aussi s'écrire sous la forme d'une modulation d'amplitude cos$\varphi_0$(t)/2) et de phase $\varphi_0$(t)/2:

$$s(t) = 2\cos(\varphi_0(t)/2)\, \cos(2\pi f_C t + \varphi_0(t)/2)\,.$$

On peut donc généraliser pour des impulsions où $\varphi(t) = h\varphi_0(t)$ ($h = 1,2,3, ...$) avec :

$$s(t) = \cos(2\pi f_C t) - (-1)^h \cos(2\pi f_C t + h\,\varphi_{\dot{a}}(t))$$

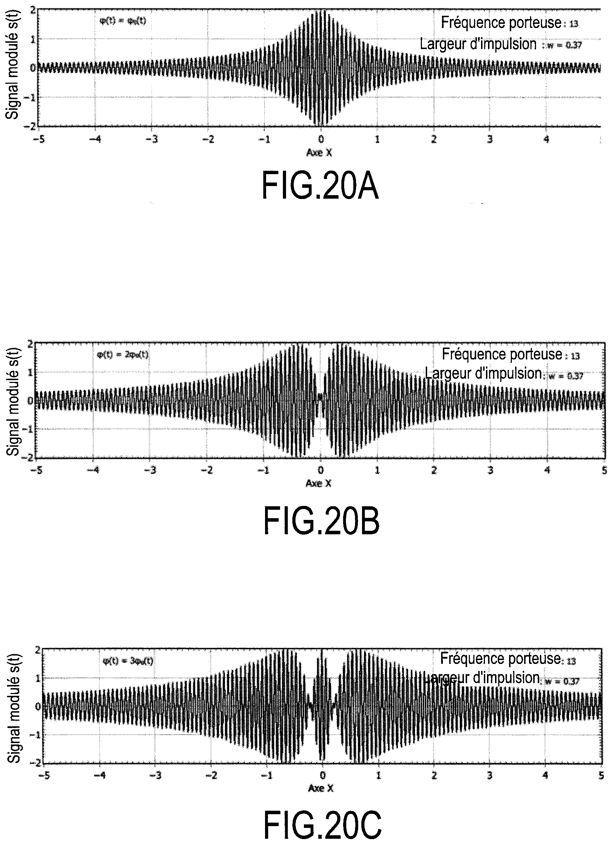

Les figures 20A à 20C montrent le signal s(t) respectivement pour h=1, 2 et 3 et une modulation de largeur $w/T_b = 0,37$ avec une porteuse fc = 13. Les signaux temporels sont orthogonaux entre eux.

Le spectre résultant est donné par la somme du spectre à BLU (terme $\cos(2\pi f_C t + \varphi(t))$) et du spectre localisé à la fréquence $f_C$ (terme $\cos(2\pi f_C t)$), c'est donc bien un spectre à Bande Latérale Unique. Il est identique à celui donné en figures 1A à 1C , pour h=1, 2 et 3 respectivement, excepté un renforcement à la fréquence $f_C$.

On donnera ci-dessous quelques exemples pratiques de générateurs d'impulsions de phase à bande latérale unique:

On peut effectuer une synthèse tout numérique de la porteuse et de sa modulation: pour des impulsions de phase générées jusqu'au rythme de quelques millions d'impulsions par seconde, et des porteuses jusqu'au GHz à l'état de l'art actuel, des méthodes numériques utilisant des processeurs rapides dédiés (en anglais « Digital Signal Processor » ou « DSP »), soit des processeurs rapides reconfigurables (en anglais « Field Programmable Gate array » ou « FPGA ») sont disponibles.

Pour des débits plus faibles, actuellement inférieurs au million d'impulsions par seconde, mais susceptibles d'augmenter avec l'évolution de la technologie, des solutions économiques basées sur des cartes de 'radio logicielle' (en anglais « software radio ») peuvent être utilisées. Après conversion digitale/analogique Les quantités sin $\varphi(t)$ et cos $\varphi(t)$ sont générées puis envoyées séparément vers des mélangeurs comme dans le mode de réalisation de la figure 6 pour multiplier la partie en phase et la partie en quadrature de la porteuse.

A titre d'alternative, toujours par synthèse numérique, la phase $\varphi(t)$ est calculée suivie d'une conversion digitale/analogique puis envoyée vers un oscillateur ou un déphaseur contrôlé en tension.

On peut également effectuer une synthèse analogique. Dans ce cas, en utilisant une phase élémentaire $\varphi_{0,s}(t)$ telle que le recouvrement entre impulsions de phases séparées de $2NT_b$ soit négligeable, la synthèse de $d\varphi(t)/dt$ s'obtient à partir de la génération de 2N séquences périodiques d'impulsions $d\varphi_{0,s}(t)/dt$ de période $2NT_b$, chaque séquence étant décalée en temps de la précédente par $T_b$. La séquence périodique

$$d\varphi_{0,s}^{\,q}(t)/dt = \sum_{k=-\infty}^{+\infty} d\varphi_{0,s}(t-(k+q)T_b)/dt \quad , -N \leq q < N \,,$$

est facile à synthétiser en générant les harmoniques de fréquence multiples de $1/2NT_b$ avec l'amplitude et la phase appropriée.

Dans l'intervalle de temps $(k-N+1/2)/2T_b \leq t < (k+N-1/2)/T_b$ on dé-multiplexe les bits pour les indexer comme $b_{k+q}$ et en utilisant la fonction porte $\cdot \Pi(t)$ de largeur $2NT_b$ on peut construire la dérivée de la phase totale :

$$d\varphi(t)/dt = \sum_{q=-N}^{+N} b_{k+q}\,\Pi(t-(k+q)T_b)\,d\varphi_{0,s}(t-(k+q)T_b)/dt$$

Cette procédure de génération d'impulsions périodiques par synthèse d'harmoniques de fréquence multiple de $1/2NT_b$ peut être facilement réalisée dans le domaine de fréquence jusqu'à des dizaines de GHz en cascadant des multiplicateurs de fréquence ou en utilisant des générateurs de peignes de fréquences pour la génération des harmoniques de base

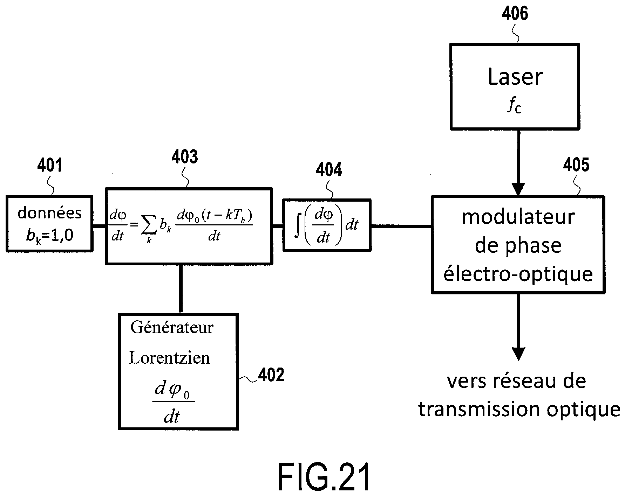

Dans le domaine optique, il est possible de moduler directement la phase de l'onde avec des modulateurs électro-optiques, la tension appliquée sur le modulateur étant proportionnelle à la variation de phase, comme illustré dans le mode de réalisation de la figure 21.

Sur la figure 21, on voit un module 401 de fourniture des données $b_k$ =1 ou 0, un générateur 402 de lorentzienne, un module 403 de génération de phase, un module 404 d'intégration de phase, un générateur laser 406 de fréquence porteuse et un modulateur de phase électro-optique 405 qui permet de moduler directement la phase de l'onde, de telle sorte que, sous l'effet d'une tension représentant la variation de phase voulue, un signal optique à modulation de phase BLU est généré dans le modulateur 405 pour être transmis dans le réseau de communication optique.

Diverses modifications et adjonctions peuvent être apportées aux exemples de réalisation décrits sans sortir du cadre de réalisation défini par les revendications annexées.

En particulier, divers modes de réalisation peuvent se combiner entre eux si une indication contraire ne figure pas dans la description.

**Revendications**

1. Procédé de modulation de phase d'une onde porteuse, comprenant une étape de création d' un ensemble de signaux $s_h(t)$ constitués d'une onde de fréquence porteuse $f_C$ dont la phase $\varphi(t)=h\varphi_0(t)$ est modulée dans le temps $t$ de telle sorte que $s_h(t)=\cos(2\pi f_C t+h\varphi_0(t))$, où $h$ est un nombre entier et **caractérisé en ce que** $\varphi_0(t)$=2 arc-tan$((t\text{-}t_0)/w_0)$, la modulation correspondant à une impulsion de phase unique centrée au temps $t_0$ de durée caractéristique $w_0$ positive et incrémentant la phase du signal $s_h(t)$ de la quantité $h2\pi$, de telle sorte que l'on génère directement un spectre de fréquence à bande latérale unique.

2. Procédé selon la revendication 1, où l'onde porteuse est de type électromagnétique.

3. Procédé selon la revendication 1, où l'onde porteuse est de type acoustique.

4. Procédé de transport d'une information binaire par codage de phase à bande latérale unique appliquant le procédé de modulation selon l'une quelconque des revendications 1 à 3, comprenant un codage binaire de la phase où l' on établit que le k$^{\text{ième}}$ bit de durée $T_b$ contribue à la phase totale $\varphi(t)$ de la porteuse par la quantité 2 $b_k$ arctan$((t\text{-}kT_b)/w)$ où $b_k$ = 1 ou 0 et la largeur $w=w_0$ est comparable ou plus petite que la durée du symbole $T_b$ ou on considère que la dérivée de la phase totale est une somme de Lorentziennes $2w/((t\text{-}kT_b)^2+w^2)$ centrées en k $T_b$ et pondérées par le bit $b_k$ puis on intègre la phase qui est ensuite adjointe à la porteuse suivant un procédé de modulation de phase, les quantités cos $\varphi(t)$ et sin $\varphi(t)$ qui sont les composantes en phase et en quadrature du signal de modulation, étant calculées et combinées aux amplitudes en phase $\cos2\pi f_C t$ et en quadrature $\sin2\pi f_C t$ de la porteuse pour obtenir le signal à transmettre sous la forme:

$$s(t)=\cos(2\pi f_C t + \varphi(t)) = \cos(2\pi f_C t)\cos\varphi(t) - \sin(2\pi f_C t)\sin\varphi(t) ..$$

5. Procédé de génération de signaux orthogonaux à bande latérale unique appliquant le procédé de modulation selon l'une quelconque des revendications 1 à 3, où, pour générer un ensemble de fonctions orthogonales $u_h(t)$, $h$ = 1,2,3, ..., $N$ sur une durée finie $T_b$. pour leur exploitation en transmission de données avec un débit 1/ $T_b$ par canal d'information, on considère d'abord le cas où $T_b$ est infini, ce qui définit une impulsion unique et on établit une base

$$u_h(t)=\frac{1}{\sqrt{2\pi}}e^{ih\,\varphi_0(t)}\sqrt{\frac{d\varphi_0(t)}{dt}}=\frac{1}{\sqrt{2\pi}}\frac{(t+iw)^{h-1}}{(t-iw)^h}$$

de fonctions orthogonales de la forme                où la phase est

$$s_h(t)=e^{ih\,\varphi_0(t)}=\frac{(t+iw)^h}{(t-iw)^h}$$

$\varphi_0(t)$=2 arctan$(t/w)$ ou on considère les signaux                puis on assure la séparation par orthogonalité de deux signaux $s_h(t)$ et $s_{h'}(t)$ en effectuant l'intégration suivante

$$\frac{1}{2\pi}\int_{-\infty}^{+\infty}s_{h'}^*(t)\,s_h(t)\frac{d\varphi_0}{dt}dt=\delta_{h,h'} \qquad \frac{d\varphi_0}{dt}=2w/(t^2+w^2)$$

où                apparaît comme un poids pour l'intégration, les signaux $s_h(t)$ étant à amplitude constante et le spectre des signaux $s_h(t)$ étant à bande latérale unique, et où $w=w_0$.

6. Procédé selon l'une quelconque des revendications 1 à 3, où pour générer un ensemble de fonctions orthogonales $s_h(t)$, $h$ = 1, 2, 3, ..., $N$ sur un intervalle fini $T_b$ pour leur exploitation en transmission de données avec un débit 1/$T_b$ par canal d'information, on considère une série périodique d'impulsions de phase espacées de la durée $T_b$ afin

$$s_h(t)=e^{ih\,\varphi_0(t,T_b)}=\left(\frac{\sin(\pi(t+iw)/T_b)}{\sin(\pi(t-iw)/T_b)}\right)^h,$$

d'obtenir des signaux périodiques de la forme                où la dérivée de la phase $\varphi_0$ est une somme périodique de fonctions lorentziennes, et où $w=w_0$, cette somme pouvant se réécrire

$$\frac{d\varphi_0}{dt}=\frac{\pi}{T_b}\cdot\frac{sh(2\pi w/T_b)}{\sin^2(\pi t/T_b)+sh^2(\pi w/T_b)}$$

sous la forme d'une fonction périodique de la forme:                où deux signaux

différents par les entiers $h$ et $h'$ vérifient une relation d'orthogonalité sur l'intervalle de temps $T_b$ :

$$\frac{1}{2\pi}\int_{-T_b/2}^{+T_b/2} s_{h'}^*(t)\, s_h(t)\, \frac{d\varphi_0}{dt}\, dt = \delta_{h,h'} \,,\quad \frac{d\varphi_0}{dt}$$ jouant le rôle de poids pour l'intégration, de telle sorte qu'en calculant $\dfrac{d\varphi_0}{dt}$ puis en procédant à une intégration pour obtenir la phase $\varphi_0(t,T_b)$ avant de synthétiser le signal $s_h(t)=e^{ih\varphi_0(t,T_b)}$, on obtient, avec une simple multiplication de la phase par un nombre entier, un jeu de signaux d'amplitude constante présentant le caractère d'orthogonalité et on obtient un spectre, discret, qui conserve la propriété de bande latérale unique.

7. Procédé d'émission en phase et hors phase de signaux binaires codés en phase à bande latérale unique appliquant le procédé de modulation selon l'une quelconque des revendications 1 à 3, où l'on module indépendamment la composante en phase et la composante en quadrature de la porteuse afin de doubler le débit d'information, le signal considéré étant de la forme suivante en étant constitué de la somme de deux amplitudes et n'étant pas à amplitude constante :

$$s(t)=\cos(2\pi f_C t + \varphi_1(t)) + \sin(2\pi f_C t + \varphi_2(t))$$

avec les phases $\varphi_1(t)=\sum_k b_{k,1}\,\varphi_0(t-kT_b)$ et $\varphi_2(t)=\sum_k b_{k,2}\,\varphi_0(t-kT_b)$ où l'on utilise deux jeux de bits indépendants $b_{k,1(2)}$ pour doubler le débit, le spectre de chacune des amplitudes hors phase et en phase étant à bande latérale unique, le signal total présentant lui-même la propriété de bande latérale unique.

8. Procédé de modulation mixte du signal d'une porteuse à la fois en amplitude et en phase en appliquant le procédé de modulation selon l'une quelconque des revendications 1 à 3, où, pour des impulsions où la phase est exprimée sous la forme $\varphi(t) = h\varphi_0(t)$ ($h = 1,2,3, \dots$) on produit un signal de la forme

$$s(t)=\cos(2\pi f_C t) - (-1)^h \cos(2\pi f_C t + h\,\varphi_à(t))$$

où le spectre résultant est à bande latérale unique.

9. Dispositif de génération d'impulsions de phase à bande latérale unique, pour la mise en oeuvre du procédé selon la revendication 1, comprenant un processeur rapide dédié DSP ou un processeur rapide reconfigurable FPGA, un convertisseur numérique/analogique, des premier et deuxième modules (105, 106) de détermination respectivement des quantités $\sin \varphi(t)$ et $\cos \varphi(t)$, des premier et deuxième mélangeurs (109, 110) pour multiplier par lesdites quantités $\sin \varphi(t)$ et $\cos \varphi(t)$ respectivement la partie en phase et la partie en quadrature de phase de l'onde de fréquence porteuse $f_c$ et un circuit additionneur (111) pour combiner les signaux délivrés par lesdits premier et deuxième mélangeurs (109, 110).

10. Dispositif de génération d'impulsions de phase à bande latérale unique, selon la revendication 9, comprenant un dispositif analogique de génération de 2N séquences périodiques d'impulsions $d\varphi_{0,s}(t)/dt$ de période $2NT_b$, chaque séquence étant décalée en temps de la précédente par $T_b$, le dispositif analogique utilisant une phase élémentaire $\varphi_{0,s}(t)$ telle que le recouvrement entre impulsions de phases séparées de $2NT_b$ soit négligeable, afin d'obtenir une synthèse de $d\varphi(t)/dt$ et un dispositif de génération d'harmoniques de fréquence multiples de $1/2NT_b$ pour synthétiser une séquence périodique de signaux $$d\varphi_{0,s}^q(t)/dt = \sum_{k=-\infty}^{+\infty} d\varphi_{0,s}(t-(k+q)T_b)/dt \,,$$ $-N \le q < N$, un dé-multiplexeur configuré pour, dans l'intervalle de temps $(k-N+1/2)/2T_b \le t < (k+N-1/2)/T_b$, démultiplexer les bits afin de les indexer comme $b_{k+q}$ et en utilisant la fonction porte $\Pi(t)$ de largeur $2NT_b$ construire la dérivée de la phase totale :

$$d\varphi(t)/dt = \sum_{q=-N}^{+N} b_{k+q}\, \Pi(t-(k+q)T_b)\, d\varphi_{0,s}(t-(k+q)T_b)/dt$$

**11.** Dispositif de démodulation d'un signal codé en phase à bande latérale unique, comprenant un oscillateur local (203) de fréquence $f_c$, des premier et deuxième mélangeurs (204, 205), et un déphaseur 0°- 90° (206) permettant d'obtenir respectivement des composantes en phase et en quadrature $\cos(\varphi(t))$ et $\sin(\varphi(t))$ du signal de modulation, un module (207) de dérivation de chacune des composantes en phase et en quadrature $\cos(\varphi(t))$ et $\sin(\varphi(t))$ du signal de modulation et de multiplication de chacune des dérivées obtenues par l'autre des composantes en phase et en quadrature $\cos(\varphi(t))$ et $\sin(\varphi(t))$ du signal de modulation, afin d'obtenir la dérivée de la phase $d\varphi/dt = \cos\varphi(t)d(\sin\varphi(t))/dt\text{-}\sin\varphi(t)d(\cos(\varphi(t))/dt$., et **caractérisé en ce qu'**il comprend un module de reconstitution d'une série d'impulsions lorentziennes initialement générées, comprenant un détecteur de seuil (208) avec une valeur moitié de l'amplitude d'une impulsion lorentzienne unique de manière à assurer la discrimination de la valeur d'un bit $b_k$ =1 ou 0 à un temps $t_k = kT_b$.

**12.** Dispositif selon la revendication 11 pour la démodulation de signaux par une base de signaux périodiques orthogonaux comprenant quatre niveaux d'amplitude incluant l'amplitude nulle, où le dispositif comprend un oscillateur local (303) de fréquence $f_c$, des premier et deuxième mélangeurs (304, 305), et un déphaseur 0°- 90° (306) permettant d'obtenir respectivement des composantes en phase et en quadrature $\cos(\varphi(t))$ et sine $(\varphi(t))$ du signal de modulation, un dispositif de détection séparée des quatre niveaux $h$=0, 1, 2 et 3 des bits quaternaires en formant pour chacun des quatre niveaux d'amplitude, par un module (307) de démodulation associé à un générateur d'impulsions de phase lorentziennes (315) lorentzien de période $T_b$, les deux quantités $R_h(t) = \left(\cos(\varphi(t) - h\varphi_0(t, T_b))\right)\dfrac{d\varphi_0}{dt}$ et $I_h(t) = \left(\sin(\varphi(t) - h\varphi_0(t, T_b))\right)\dfrac{d\varphi_0}{dt}$ , un dispositif (308) de détermination de la convolution avec une fonction porte de largeur en temps $T_b$ donnant $\overline{R_h}(t) = \displaystyle\int_{t-T_b/2}^{t+T_b/2} R_h(t-\tau)d\tau$ et $\overline{I_h}(t) = \displaystyle\int_{t-T_b/2}^{t+T_b/2} I_h(t-\tau)dt$ à partir des quantités $R_h(t)$ et $I_h(t)$, un dispositif (309) de calcul de la quantité $\overline{R_h}(t)^2 + \overline{I_h}(t)^2$ et un dispositif (310 à 313) de détection de seuil configuré pour déterminer qu'un pic observé dans cette quantité $\overline{R_h}(t)^2 + \overline{I_h}(t)^2$ à un instant $t = kT_b$ pour le niveau $h$=0, 1, 2 ou bien 3 signale que le bit $b_k$ vaut $h$.

**13.** Dispositif selon la revendication 9 pour la génération d'impulsions de phase à bande latérale unique dans le domaine optique, comprenant un module (401) de fourniture des données $b_k$ = 1 ou 0, un générateur (402) de lorentzienne, un module (403) de génération de phase, un module (404) d'intégration de phase, un générateur laser (406) de fréquence porteuse et un modulateur de phase électro-optique (405) configuré pour moduler directement la phase de l'onde, de telle sorte que, sous l'effet d'une tension proportionnelle à la variation de phase voulue, un signal optique à modulation de phase BLU est généré dans le modulateur (405) pour être transmis dans un réseau de communication optique.

**Patentansprüche**

**1.** Verfahren zur Phasenmodulation einer Trägerwelle, umfassend einen Schritt zum Erzeugen eines Satzes von Signalen $s_h(t)$, die aus einer Welle mit einer Trägerfrequenz $f_c$ bestehen, deren Phase $\varphi(t) = h\varphi_0(t)$ über die Zeit $t$ derart moduliert wird, dass $s_h(t) = \cos(2\pi f_c t + h\varphi_0(t))$ wobei $h$ für eine ganze Zahl steht, und **dadurch gekennzeichnet, dass** $\varphi_0(t) = 2\arctan((t - t_0) / w_0)$, wobei die Modulation einem einphasigen Impuls entspricht, der um den Zeitpunkt $t_0$ der charakteristischen positiven Dauer $w_0$ zentriert ist und die Phase des Signals $s_h(t)$ um die Menge $h2\pi$ derart erhöht, dass direkt ein Einseitenband-Frequenzspektrum erzeugt wird.

**2.** Verfahren nach Anspruch 1, wobei die Trägerwelle vom elektromagnetischen Typ ist.

**3.** Verfahren nach Anspruch 1, wobei die Trägerwelle vom Schalltyp ist.

4. Verfahren zum Transport einer Binärinformation durch Einseitenband-Phasencodierung unter Verwendung des Modulationsverfahrens nach einem der Ansprüche 1 bis 3, umfassend eine Binärcodierung der Phase, wobei festgelegt wird, dass das k-te Bit der Dauer $T_b$ zu der Gesamtphase $\varphi(t)$ der Trägerwelle mit der Menge 2 $b_k$ arctan(($t - kT_b$) / $w$) beiträgt, wobei $b_k$ = 1 oder 0 und die Breite $w = w_0$ kleiner gleich Symboldauer $T_b$ ist, oder davon ausgegangen wird, dass die Ableitung der Gesamtphase eine Summe von Lorentz-Funktionen $2w / ((t - kT_b)^2 + w^2)$ ist, die um k $T_b$ zentriert und durch das Bit $b_k$ gewichtet sind, und dann die Phase integriert wird, die anschließend zu der Trägerwelle gemäß einem Verfahren zur Phasenmodulation addiert wird, wobei die Mengen cos$\varphi(t)$ und sin$\varphi(t)$, bei denen es sich um die Gleichphasen- und Quadraturkomponenten des Modulationssignals handelt, berechnet und mit Gleichphasen- und Quadraturamplituden cos2$\pi f_c t$ bzw. sin2$\pi f_c t$ der Trägerwelle kombiniert werden, um das zu übertragende Signal in folgender Form zu erhalten:

$$s(t) = \cos\left(2\pi f_c t + \varphi(t)\right) = \cos(2\pi f_c t)\cos\varphi(t) - \sin(2\pi f_c t)\sin\varphi(t).$$

5. Verfahren zum Erzeugen von orthogonalen Einseitenband-Signalen unter Verwendung des Modulationsverfahrens nach einem der Ansprüche 1 bis 3, wobei zum Erzeugen eines Satzes von orthogonalen Funktionen $u_h(t)$, $h$ = 1,2,3, ..., $N$ über eine endliche Dauer $T_b$ zu deren Verwendung bei der Übertragung von Daten mit einer Rate von $1/T_b$ je Datenkanal zunächst der Fall betrachtet wird, in dem $T_b$ unendlich ist, wodurch ein Einzelimpuls definiert

$$u_h(t) = \frac{1}{\sqrt{2\pi}} e^{ih\,\varphi 0(t)} \sqrt{\frac{d\varphi_0(t)}{dt}} = \frac{1}{\sqrt{2\pi}} \frac{(t+iw)^{h-1}}{(t-iw)^h}$$

und eine Grundlage von orthogonalen Funktionen der Form

$$s_h(t) = e^{ih\,\varphi 0(t)} = \frac{(t+iw)^h}{(t-iw)^h}$$

festgelegt wird, wobei die Phase $\varphi(t)$ = 2 arctan($t/w$) ist, oder die Signale betrachtet werden und dann sichergestellt wird, dass die beiden Signale $s_h(t)$ und $s_{h'}(t)$ orthogonal getrennt sind, indem die folgende Integration $\frac{1}{2\pi}\int_{-\infty}^{+\infty} s_{h'}^*(t) s_h(t) \frac{d\varphi_0}{dt} dt = \delta_{h,h'}$ durchgeführt wird, wobei $\frac{d\varphi_0}{dt} = 2w / \left(t^2 + w^2\right)$ als Gewichtung für die Integration gilt, wobei die Signale $s_h(t)$ eine konstante Amplitude aufweisen und das Spektrum der Signale $s_h(t)$ ein einziges Seitenband aufweist und wobei $w = w_0$.

6. Verfahren nach einem der Ansprüche 1 bis 3, wobei zum Erzeugen eines Satzes von orthogonalen Funktionen $s_h(t)$, $h$ = 1,2,3, ..., N über ein endliches Intervall $T_b$ zu deren Verwendung bei der Übertragung von Daten mit einer Rate von $1/T_b$ je Datenkanal eine periodische Reihe von Phasenimpulsen betrachtet wird, die um die Dauer $T_b$ beabstandet sind, um periodische Signale der Form $s_h(t) = e^{ih\,\varphi_0(t,T_b)} = \left(\frac{\sin(\pi(t+iw)/T_b)}{\sin(\pi(t-iw)/T_b)}\right)^h$ zu erhalten, wobei die Ableitung der Phase $\varphi_0$ eine periodische Summe von Lorentz-Funktionen ist und wobei $w = w0$, wobei diese Summe als periodische Funktion der folgenden Form umgeschrieben werden kann: $\frac{d\varphi_0}{dt} = \frac{\pi}{T_b} \cdot \frac{sh(2\pi w / T_b)}{sin^2(\pi t / T_b) + sh^2(\pi w / T_b)}$, wobei zwei sich um die ganzen Zahlen $h$ und $h'$ unterscheidende Signale eine Orthogonalitätsbeziehung über das Zeitintervall $T_b$ bestätigen: $\frac{1}{2\pi}\int_{-T_b/2}^{+T_b/2} s_{h'}^*(t) s_h(t) \frac{d\varphi_0}{dt} dt = \delta_{h,h'}$, wobei $\frac{d\varphi_0}{dt}$ die Rolle einer Gewichtung für die Integration derart innehat, dass durch Berechnen von $\frac{d\varphi_0}{dt}$ und dann Durchführen einer Integration, um die Phase $\varphi_0(t, T_b)$ vor dem Synthetisieren des Signals $s_h(t) = e^{ih\varphi_0(t,T_b)}$ zu erhalten, durch eine einfache Multiplikation der Phase mit einer ganzen Zahl ein Satz von Signalen mit konstanter Amplitude erhalten wird, der die Orthogonalitätseigenschaft aufweist, und ein diskretes Spektrum erhalten wird, das die Eigenschaft eines einzigen Seitenbands beibehält.

7. Verfahren zum gleichphasigen und phasenverschobenen Senden von phasencodierten Einseitenband-Binärsignalen unter Verwendung des Modulationsverfahrens nach einem der Ansprüche 1 bis 3, wobei die Gleichphasenkomponente und die Quadraturkomponente der Trägerwelle unabhängig moduliert werden, um die Datenrate zu verdoppeln, wobei das betrachtete Signal die folgende Form aufweist, wobei es aus der Summe zweier Amplituden gebildet ist und keine konstante Amplitude aufweist:

$$s(t) = \cos\bigl(2\mu f_c t + \varphi_1(t)\bigr) + \sin\bigl(2\mu f_c t + \varphi_2(t)\bigr)$$

mit den Phasen $\varphi_1(t) = \sum_k b_{k,1} \varphi_0(t - kT_b)$ und $\varphi_2(t) = \sum_k b_{k,2} \varphi_0(t - kT_b)$, wobei zwei unabhängige Sätze von Bits $b_{k,1(2)}$ verwendet werden, um die Rate zu verdoppeln, wobei das Spektrum jeder der phasenverschobenen und gleichphasigen Amplituden ein einziges Seitenband aufweist, wobei das Gesamtsignal selbst die Eigenschaft eines einzigen Seitenbands aufweist.

8. Verfahren zur gemischten Modulation des Signals einer Trägerwelle sowohl in der Amplitude als auch in der Phase unter Verwendung des Modulationsverfahren nach einem der Ansprüche 1 bis 3, wobei für die Impulse, bei denen die Phase in der Form $\varphi(t) = h\varphi_0(t)$ ($h$ = 1, 2, 3, ...) ausgedrückt wird, ein Signal der Form

$$s(t) = \cos(2\mu f_c t) - (-1)^h \cos\bigl(2\mu f_c t + h\varphi_{\grave{a}}(t)\bigr)$$

erzeugt wird, wobei das sich ergebende Spektrum ein einziges Seitenband aufweist.

9. Vorrichtung zum Erzeugen von Einseitenband-Phasenimpulsen zur Umsetzung des Verfahrens nach Anspruch 1, umfassend einen dedizierten schnellen DSP-Prozessor oder einen rekonfigurierbaren schnellen FPGA-Prozessor, einen Digital-Analog-Umsetzer, ein erstes und ein zweites Modul (105, 106) zur Bestimmung der Mengen $\sin\varphi(t)$ bzw. $\cos\varphi(t)$, einen ersten und einen zweiten Mischer (109, 110) zum Multiplizieren der Mengen $\sin\varphi(t)$ und $\cos\varphi(t)$ mit dem Gleichphasenanteil bzw. dem Quadraturphasenanteil der Welle mit der Trägerfrequenz $f_c$ und eine Addierschaltung (111) zum Kombinieren der von dem ersten und zweiten Mischer (109, 111) gelieferten Signale.

10. Vorrichtung zum Erzeugen von Einseitenband-Phasenimpulsen nach Anspruch 9, umfassend eine Analogvorrichtung zum Erzeugen von 2N periodischen Impulssequenzen $d\varphi_{0,s}(t) / dt$ mit der Periode $2NT_b$, wobei jede Sequenz von der vorhergehenden um $T_b$ zeitlich versetzt ist, wobei die Analogvorrichtung eine Grundphase $\varphi_{0,s}(t)$ verwendet, sodass die Überlappung zwischen um $2NT_b$ getrennten Phasenimpulsen vernachlässigbar ist, um eine Synthese von $d\varphi(t) / dt$ zu erhalten, und eine Vorrichtung zum Erzeugen von Harmonischen mit mehreren Frequenzen von $1/2NT_b$, um eine periodische Signalsequenz

$$\frac{d\varphi_{0,s}^{q}(t)}{dt} = \sum_{k=-\infty}^{+\infty} d\varphi_{0,s}(t - (k + q)T_b) / dt,$$

$-N \le q < N$ zu synthetisieren, einen Demultiplexer, der dazu ausgestaltet ist, in dem Zeitintervall $(k - N+1/2)/2T_b \le t < (k+N - 1/2)/T_b$ Bits zu demultiplexen, um sie als $b_{k+q}$ zu indexieren und unter Verwendung der Rechteckfunktion $\Pi(t)$ der Breite $2NT_b$ die folgende Ableitung der Gesamtphase zu bilden:

$$d\varphi(t) / dt = \sum_{q=-N}^{+N} b_{k+q} \prod (t - (k + q)T_b) \, d\varphi_{0,s}(t - (k + q)T_b) / dt$$

11. Vorrichtung zur Demodulation eines phasencodierten Einseitenband-Signals, umfassend einen Lokaloszillator (203) der Frequenz $f_c$, einen ersten und einen zweiten Mischer (204, 205) und einen 0°- zu 90°-Phasenschieber (206), der es ermöglicht, Gleichphasen- und Quadraturkomponenten $\cos(\varphi(t)$ bzw. $\sin\varphi(t))$ des Modulationssignals zu erhalten, ein Modul (207) zur Ableitung jeder der Gleichphasen- und Quadraturkomponenten $\cos(\varphi(t)$ bzw. $\sin\varphi(t))$ des Modulationssignals und zur Multiplikation jeder der erhaltenen Ableitungen mit der anderen der Gleichphasen- und Quadraturkomponenten $\cos(\varphi(t)$ bzw. $\sin\varphi(t))$ des Modulationssignals, um die Ableitung der Phase $d\varphi / dt = cos\varphi(t)d(sin\varphi(t)) / dt - sin\varphi(t)d(cos\varphi(t)) / dt$ zu erhalten, und **dadurch gekennzeichnet, dass** sie ein Modul zur Wiederherstellung einer Reihe von ursprünglich erzeugten Lorentz-Impulsen umfasst, umfassend einen Schwellenwertdetektor (208) mit einem Wert einer halben Amplitude eines einzigen Lorentz-Impulses, um die Unterscheidung des Werts eines Bits $b_k$ = 1 oder 0 zu einem Zeitpunkt $t_k = kT_b$ sicherzustellen.

12. Vorrichtung nach Anspruch 11 zur Demodulation von Signalen mit einer Grundlage von periodischen orthogonalen Signalen, umfassend vier Amplitudenstufen, einschließlich der Nullamplitude, wobei die Vorrichtung einen Lokaloszillator (303) der Frequenz $f_c$, einen ersten und einen zweiten Mischer (304, 305) und einen 0°- zu 90°-Phasenschieber (306), der es ermöglicht, Gleichphasen- und Quadraturkomponenten cos($\varphi(t)$ bzw. sin$\varphi(t)$) des Modulationssignals zu erhalten, eine Vorrichtung zur getrennten Erkennung der vier Stufen $h$ = 0, 1, 2 und 3 von quaternären Bits durch Bilden, für jede der vier Amplitudenstufen durch ein Demodulationsmodul (307), das mit einem Lorentz-Impulsphasengenerator (315) der Periode $T_b$ verbunden ist, der zwei Mengen

$$R_h(t) = \left(\cos\left(\varphi(t) - h\varphi_0(t, T_b)\right)\right)\frac{d\varphi_0}{dt} \quad \text{und} \quad I_h(t) = \left(\sin\left(\varphi(t) - h\varphi_0(t, T_b)\right)\right)\frac{d\varphi_0}{dt},$$

eine Vorrichtung (308) zur Bestimmung der Faltung mit einer Rechteckfunktion der Breite in Abhängigkeit der Zeit $T_b$ mit

$$\overline{R_h}(t) = \int_{t-T_b/2}^{t+T_b/2} R_h(t-\tau)d\tau$$

und

$$\overline{I_h}(t) = \int_{t-T_b/2}^{t+T_b/2} I_h(t-\tau)d\tau$$

aus den Mengen $R_h(t)$ und $I_h(t)$, eine Vorrichtung (309) zur Berechnung der Menge $\overline{R_h}(t)^2 + \overline{I_h}(t)^2$ und eine Vorrichtung (310 bis 313) zur Schwellenwerterkennung, die dazu ausgestaltet ist, zu bestimmen, dass eine in dieser Menge $\overline{R_h}(t)^2 + \overline{I_h}(t)^2$ zu einem Zeitpunkt $t = kT_b$ für die Stufe $h$ = 0, 1, 2 oder auch 3 festgestellte Spitze anzeigt, dass das Bit $b_k$ gleich $h$ ist.

13. Vorrichtung nach Anspruch 9 zum Erzeugen von Einseitenband-Phasenimpulsen im optischen Bereich, umfassend ein Modul (401) zur Bereitstellung von Daten $b_k$ = 1 oder 0, einen Lorentz-Generator (402), ein Phasenerzeugungsmodul (403), ein Phasenintegrationsmodul (404), einen Lasergenerator (406) für eine Trägerfrequenz und einen elektrooptischen Phasenmodulator (405), der dazu ausgestaltet ist, die Phase der Welle direkt derart zu modulieren, dass unter Einwirkung einer zu der gewünschten Phasenvariation proportionalen Spannung ein optisches ESB-Phasenmodulationssignal in dem Modulator (405) zur Übertragung in einem optischen Kommunikationsnetz erzeugt wird.

## Claims

1. A method of phase modulating a carrier wave, the method comprising a step of creating a set of signals $s_h(t)$ constituted by a wave of carrier frequency $f_c$ and of phase $\varphi(t) = h\varphi_0(t)$ that is modulated in time $t$ in such a manner that $s_h(t) = \cos(2\pi f_c t + h\varphi_0(t))$, where $h$ is an integer and **characterized in that** $\varphi_0(t) = 2 \arctan((t-t_0)/w_0)$, the modulation corresponding to a single phase pulse centered on a time $t_0$, and of positive characteristic duration $w_0$, and incrementing the phase of the signal $s_h(t)$ by the quantity $h2\pi$, in such a manner as to generate a single sideband frequency spectrum directly.

2. A method according to claim 1, wherein the carrier wave is of electromagnetic type.

3. A method according to claim 1, wherein the carrier wave is of acoustic type.

4. A method of transporting binary information by single sideband phase coding by applying the method of modulation according to any one of claims 1 to 3, comprising a binary coding of the phase with establishing that the $k^{th}$ bit of duration $T_b$ contributes the quantity $2b_k\arctan((t-kT_b)/w)$ to the total phase $\varphi(t)$ of the carrier, where $b_k$=1 or 0, and where the width $w = w0$ is comparable to or smaller than the symbol duration $T_b$, or else considering that the derivative of the total phase is a sum of Lorentzian functions $2w/((t-kT_b)^2 + w^2)$ centered on $kT_b$ and weighted by the bit $b_k$, and then integrating the phase, which is then added to the carrier using a phase modulation method, the quantities $\cos\varphi(t)$ and $\sin\varphi(t)$, which are the in-phase and quadrature components of the modulation signal, being calculated and combined with the in-phase amplitude $\cos 2\pi f_c t$ and the quadrature amplitude $\sin 2\pi f_c t$ of the carrier in order to obtain the signal for transmission in the form:

$$s(t) = \cos(2\pi f_C t + \varphi(t)) = \cos(2\pi f_C t) \cos \varphi(t) - \sin(2\pi f_C t) \sin \varphi(t) \; .$$

5. A method of generating single sideband orthogonal signals by applying the method of modulation according to any one of claims 1 to 3, wherein, for generating a set of orthogonal functions $u_h(t)$, $h = 1,2,3, ...,N$ over a finite duration $T_b$ for use in transmitting data at a rate of $1/T_b$ per data channel, initially either considering the situation in which $T_b$ is infinite, thereby defining a single pulse, and establishing a base of orthogonal functions of the form:

$$u_h(t) = \frac{1}{\sqrt{2\pi}} e^{ih \, \varphi_0(t)} \sqrt{\frac{d\varphi_0(t)}{dt}} = \frac{1}{\sqrt{2\pi}} \frac{(t+iw)^{h-1}}{(t-iw)^h}$$

$$s_h(t) = e^{ih \, \varphi_0(t)} = \frac{(t+iw)^h}{(t-iw)^h}$$

where the phase is $\varphi_0(t) = 2 \arctan(t/w)$, or else considering the signals $s_h(t)$ and then ensuring that two signals $s_h(t)$ and $s_{h'}(t)$ are orthogonally separated by performing the following integration:

$$\frac{1}{2\pi} \int_{-\infty}^{+\infty} s_{h'}^{*}(t) s_h(t) \frac{d\varphi_0}{dt} dt = \delta_{h,h'}$$

where $\dfrac{d\varphi_0}{dt} = 2w/(t^2 + w^2)$ appears as a weight for the integration, the signals $s_h(t)$ being at constant amplitude, and the spectrum of the signals $s_h(t)$ being a single sideband spectrum and where $w = w0$.

6. A method according to any one of claims 1 to 3 wherein for generalizing a set of orthogonal functions $s_h(t)$, $h = 1, 2, 3, ... N$ over a finite time interval $T_b$ for their use for data transmission with a throughput of $1/T_b$ per information channel, considering a periodic series of phase pulses spaced apart by the duration $T_b$ in order to obtain periodic signals of the following form:

$$s_h(t) = e^{ih \, \varphi_0(t,T_b)} = \left( \frac{\sin(\pi(t+iw)/T_b)}{\sin(\pi(t-iw)/T_b)} \right)^h \; ;$$

where the derivative of the phase $\varphi_0$ is a periodic sum of Lorentzian functions and where $w = w0$, which sum may be rewritten as a periodic function having the form:

$$\frac{d\varphi_0}{dt} = \frac{\pi}{T_b} \cdot \frac{sh(2\pi w/T_b)}{\sin^2(\pi t/T_b) + sh^2(\pi w/T_b)}$$

where two signals differing by the integers $h$ and $h'$ satisfy an orthogonality relationship over the time interval $T_b$:

$$\frac{1}{2\pi} \int_{-T_b/2}^{+T_b/2} s_{h'}^{*}(t) s_h(t) \frac{d\varphi_0}{dt} dt = \delta_{h,h'} \; ;$$

$\dfrac{d\varphi_0}{dt}$ acting as a weight for the integration, such that by calculating $\dfrac{d\varphi_0}{dt}$ and then proceeding with integration in order to obtain the phase $\varphi_0(t,T_b)$ before synthesizing the signal $s_h(t)=e^{th\varphi 0(t,T_b)}$, a constant amplitude signal set is obtained presenting the characteristic of orthogonality, and a discrete spectrum is obtained that conserves the single sideband property, merely by performing a simple multiplication of the phase by an integer.

7. A method of transmitting single sideband phase-coded binary signals in-phase and out-of-phase by applying the method of modulation according to any one of claims 1 to 3, independently modulating the in-phase component and the quadrature component of the carrier in order to double the bit rate, the signal under consideration having the following form and being constituted by the sum of two amplitudes and not being of constant amplitude:

$$s(t) = \cos(2\pi f_C t + \varphi_1(t)) + \sin(2\pi f_C t + \varphi_2(t))$$

with the phases $\varphi_1(t) = \sum_k b_{k,1}\,\varphi_0(t - kT_b)$ and $\varphi_2(t) = \sum_k b_{k,2}\,\varphi_0(t - kT_b)$ , where two independent sets of bits $b_{k,1(2)}$ are used to double the bit rate, the spectrum of each of the out-of-phase and in-phase amplitudes being a single sideband spectrum, the total signal itself presenting the single sideband property.

8. A method of combined modulation of the signal of a carrier combining both amplitude modulation and phase modulation by applying the method of modulation according to any one of claims 1 to 3, wherein, for pulses where the phase is expressed in the form $\varphi(t) = h\varphi_0(t)$ ($h$ = 1, 2, 3, ... ), producing a signal of the form:

$$s(t) = \cos(2\pi f_C t) - (-1)^h \cos(2\pi f_C t + h\varphi_a(t))$$

where the resulting spectrum is a single sideband spectrum.

9. A device for generating single sideband phase pulses for performing the method according to claim 1, the device comprising a dedicated fast DSP processor or a reconfigurable fast FPGA processor, a digital-to-analog converter, first and second modules (105, 106) respectively for determining the quantities $\sin\varphi(t)$ and $\cos\varphi(t)$, first and second mixers (109, 110) for multiplying the in-phase part and the phase quadrature part of the wave of carrier frequency $f_c$ respectively by said quantities $\sin\varphi(t)$ and $\cos\varphi(t)$, and an adder circuit (111) for combining the signals delivered by said first and second mixers (109, 110).

10. A device for generating single sideband phase pulses for performing the method according to claim 9, the device comprising an analog device for generating 2$N$ periodic sequences of pulses $d\varphi_{0,s}(t)/dt$ of period 2$NT_b$, each sequence being offset in time from the preceding sequence by $T_b$, the analog device using an elementary phase $\varphi_{0,s}(t)$ such that the overlap between phase pulses separated by 2$NT_b$ is negligible, in order to synthesize $d\varphi(t)/dt$, and a device for generating frequency harmonics that are multiples of 1/2$NT_b$ in order to synthesize a periodic sequence of signals

$$d\varphi_{0,s}^{\,q}(t)/dt = \sum_{k=-\infty}^{+\infty} d\varphi_{0,s}(t - (k+q)T_b)/dt \;,\; -N \le q < N \;;$$

and
a demultiplexer configured to act in the time interval

$$(k - N + 1/2)/2T_b \le t < (k + N - 1/2)/T_b$$

to demultiplex the bits in order to index them as $b_{k+q}$, and by using the gate function $\Pi(t)$ of width 2$NT_b$ to construct the total phase derivative:

$$d\varphi(t)/dt = \sum_{q=-N}^{+N} b_{k+q}\,\Pi(t - (k+q)T_b)\,d\varphi_{0,s}(t - (k+q)T_b)/dt$$

**11.** A device for demodulating a single sideband phase coded signal, comprising a local oscillator (203) of frequency $f_c$, first and second mixers (204, 205), and a 0°-90° phase shifter (206) for obtaining respectively the in-phase and quadrature components $\cos(\varphi(t))$ and $\sin(\varphi(t))$ of the modulation signal, a module (207) for differentiating each of the in-phase and quadrature components $\cos(\varphi(t))$ and $\sin(\varphi(t))$ of the modulation signal and for multiplying each of the derivatives obtained by the other one of the in-phase and quadrature components $\cos(\varphi(t))$ and $\sin(\varphi(t))$ of the modulation signal in order to obtain the phase derivative:

$d\varphi/dt = \cos\varphi(t)d(\sin\varphi(t))/dt - \sin\varphi(t)d(\cos\varphi(t))/dt$; and **characterized in that** it comprises a module for reconstituting an initially generated series of Lorentzian function pulses, the module comprising a threshold detector (208) with a value of half the amplitude of a single Lorentzian function pulse so as to discriminate the value of a bit $b_k = 1$ or 0 at a time $t_k = kT_b$.

**12.** A device according to claim 11 for demodulating signals by a base of orthogonal periodic signals comprising four amplitude levels including zero amplitude, the device comprising a local oscillator (303) of frequency $f_c$, first and second mixers (304, 305), and a 0°-90° phase shifter (306) serving to obtain respectively the in-phase and quadrature components $\cos(\varphi(t))$ and $\sin(\varphi(t))$ of the modulation signal, a device for separately detecting the four levels $h=0$, 1, 2, and 3 of quaternary bits by using a demodulation module (307) associated with a Lorentzian generator for generating Lorentzian phase pulses (315) of period $T_b$, to form the following two quantities for each of the four amplitude levels:

$$R_h(t) = \left(\cos(\varphi(t) - h\varphi_0(t,T_b))\right)\frac{d\varphi_0}{dt} \quad \text{and} \quad I_h(t) = \left(\sin(\varphi(t) - h\varphi_0(t,T_b))\right)\frac{d\varphi_0}{dt}$$

a device (308) for determining the convolution with a gate function of time width $T_b$ giving:

$$\overline{R_h}(t) = \int_{t-T_b/2}^{t+T_b/2} R_h(t-\tau)d\tau \quad \text{and} \quad \overline{I_h}(t) = \int_{t-T_b/2}^{t+T_b/2} I_h(t-\tau)dt$$

from the quantities $R_h(t)$ and $I_h(t)$, a device (309) for calculating the quantity $\overline{R_h}(t)^2 + \overline{I_h}(t)^2$, and a threshold detection device (310 to 313) configured to determine that a peak observed in the quantity $\overline{R_h}(t)^2 + \overline{I_h}(t)^2$ at an instant $t = kT_b$ for the level $h=0$, 1, 2, or else 3 indicates that the bit $b_k$ is equal to $h$.

**13.** A device according to claim 9 for generating single sideband phase pulses in the optical domain, comprising a module (401) for supplying data $b_k=1$ or 0, a Lorentzian function generator (402), a phase generator module (403), a phase integrator module (404), a laser generator (406) for generating a carrier frequency, and an electro-optical phase modulator (405) configured to modulate the phase of the wave directly in such a manner that, under the effect of a voltage proportional to the desired phase variation, an SSB phase modulation optical signal is generated in the modulator (405) for transmission in an optical communications network.

FIG.1A  FIG.1B  FIG.1C

FIG.2A  FIG.2B

FIG.3A  FIG.3B

FIG.4

FIG.5A

FIG.5B

FIG.6

FIG.7

FIG.8A

FIG.8B

FIG.9

FIG.10

FIG.11

FIG.12

FIG.13

FIG.14A

FIG.14B

FIG.14C

FIG.14D

FIG.14E

FIG.15A

FIG.15B

FIG.15C

FIG.16A

FIG.16B

FIG.18A

FIG.18B

FIG.17

FIG.19

FIG.20A

FIG.20B

FIG.20C

**406**

Laser
$f_\text{C}$

**401**

données
$b_\text{k}$=1,0

**403**

$$\frac{d\varphi}{dt} = \sum_k b_k \frac{d\varphi_0(t - kT_b)}{dt}$$

**404**

$$\int \left( \frac{d\varphi}{dt} \right) dt$$

**405**

modulateur
de phase
électro-optique

**402**

Générateur
Lorentzien

$$\frac{d\varphi_0}{dt}$$

vers réseau de
transmission optique

FIG.21

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 1449382 A
- US 1666206 A
- US 20070092018 A1
- US 3204034 A
- US 3384715 A
- US 3488445 A
- US 2977417 A

**Littérature non-brevet citée dans la description**

- **D. K. WEAVER JR.** A third method of generation and detection of single-sideband signais. *Proceeding of the IRE,* Juin 1956, 1703-1705
- **H. E. ROWE ; V. K. PRABHU.** Power spectrum of a digital, frequency-modulation signal. *The Bell System Technical Journal,* 1975, vol. 54 (6), 1095-1125